# EUROPEAN PATENT SPECIFICATION

(11) **EP 3 465 332 B1**
(45) Date of publication and mention of the grant of the patent: **21.07.2021**
(21) Application number: 16904274.4
(22) Date of filing: 06.06.2016
(51) Int. Cl.: G02F 1/1333, C09K 11/02, C09K 11/08, H01L 33/50, C09K 11/06, C09B 69/00, G02F 1/1335, G02F 1/13357, G02B 5/20, H01L 27/32

(54) **LIGHT EMITTING APPARATUS AND ELECTRONIC DEVICE COMPRISING THE SAME**
LICHTEMITTIERENDE VORRICHTUNG UND ELEKTRONISCHE VORRICHTUNG DAMIT
DIODE ÉLECTROLUMINESCENTE ET DISPOSITIF ÉLECTRONIQUE COMPRENANT LA MÊME

(43) Date of publication of application: 10.04.2019
(73) Proprietor: Dow Global Technologies LLC, Midland, MI 48674 (US); Rohm and Haas Electronic Materials LLC, Marlborough, MA 01752 (US); Rohm And Haas Electronic Materials Korea Ltd., Cheonan-si, Chungcheongnam-do 331-980 (KR)
(72) Inventor: WANG, Xiuyan, Shanghai 201203 (CN); LI, Yang, Shanghai 201203 (CN); REN, Xiaofan, Shanghai 201203 (CN); LV, Bo, Shanghai 201203 (CN); HU, Nan, Shanghai 201203 (CN); TREFONAS, Peter, III, Marlborough MA 01752 (US); KIM, Yongcheol, Yuseong-gu Daejeon 34067 (KR); HUANG, Yan, Shanghai 201203 (CN)
(74) Representative: Houghton, Mark Phillip
(86) International application number: PCT/CN2016/084927
(87) International publication number: WO 2017/210821

(56) References cited:
- CN-A- 101 644 850
- CN-A- 102 109 697
- CN-A- 102 109 697
- US-A1- 2006 121 371
- US-A1- 2016 033 823
- US-A1- 2016 033 823
- OW H ET AL: "Bright and Stable Core-Shell fluorescent Nanoparticles", NANO LETTERS, AMERICAN CHEMICAL SOCIETY, US, vol. 5, 1 January 2005 (2005-01-01), pages 113-117, XP002486300, ISSN: 1530-6984, DOI: 10.1021/NL0482478 [retrieved on 2004-12-17]
- HAILIN WANG ET AL: "Synthesis of Silica Encapsulated Perylenetetracarboxylic Diimide Core-Shell Nanoellipsoids", CHEMISTRY OF MATERIALS, vol. 23, no. 21, 8 November 2011 (2011-11-08), pages 4748-4755, XP055644665, ISSN: 0897-4756, DOI: 10.1021/cm2017328
- HEMALI RATHNAYAKE ET AL: "Perylenediimide functionalized bridged-siloxane nanoparticles for bulk heterojunction organic photovoltaics", NANOSCALE, vol. 4, no. 15, 1 January 2012 (2012-01-01), page 4631, XP055644673, United Kingdom ISSN: 2040-3364, DOI: 10.1039/c2nr30538k
- QIAN LIU ET AL: "A General Strategy for Biocompatible, High-Effective Upconversion Nanocapsules Based on Triplet-Triplet Annihilation", JOURNAL OF THE AMERICAN CHEMICAL SOCIETY, vol. 135, no. 13, 3 April 2013 (2013-04-03), pages 5029-5037, XP055182894, ISSN: 0002-7863, DOI: 10.1021/ja3104268
- HOOISWENG OW ET AL.: 'Bright and Stable Core-Shell Fluorescent Silica Nanoparticles' NANO LETTERS vol. 5, no. 1, 17 December 2004, pages 113 - 116, XP002486300

## Description

### FIELD OF THE INVENTION

The present invention relates to a light emitting apparatus and an electronic device comprising the same.

### INTRODUCTION

Conventional liquid crystal display (LCD) devices include an LCD unit and a backlight unit which uniformly illuminates the LCD unit with white light. A main factor that determines the maximum color performance of LCD devices is the spectral interaction between the light emitted from the backlight unit and the color filter array of the LCD unit. The color filter array consists of millions of individually addressable pixels, each of which are made up of red (R), green (G) and blue (B) sub-pixels.

A major problem of conventional LCD devices is the large light loss associated with the LCD unit above the backlight source. Typically only less than 10% of light emitted from the backlight source is used and the remaining over 90% is absorbed by the LCD unit, including a polarizing filter, a thin film transistor (TFT) array, a liquid crystal cell, and a color filter array. In particular, transmittance through the RGB sub-pixel color filter is the lowest (about 30%), since each sub-pixel only allows one of the three primary colors to pass through.

Another problem of conventional LCD devices is the bichromatic white backlight made of blue light emitting diode (LED) chip with yttrium aluminum garnet (YAG) yellow phosphor coating. This bichromatic white backlight is not an ideal match with the spectral transmission of the RGB color filters, leading to unsatisfactory color quality of the display. To address this problem, new display technologies, such as RGB LEDs, wide color gamut phosphors, and quantum dot (QD) enhanced films, have recently been introduced to improve the color performance of LCD devices. However, there remains a need to provide a light emitting apparatus affording high quality colors, e.g., both rich and saturated colors, and energy economy.

CN102109697 discloses a liquid crystal display device, comprising a backlight module, a glass substrate and a transparent matrix layer which are orderly arranged, wherein the transparent matrix layer is arranged on the glass substrate; a color filtering film is arranged on the transparent matrix layer; the transparent matrix layer comprises a first transparent matrix unit, a second transparent matrix unit and a third transparent matrix unit; the first transparent matrix unit is coated with fluorescent powders which can generate red lights under excitation energy; the second transparent matrix unit is coated with the fluorescent powders which can generate green lights under the excitation energy; and the third transparent matrix unit is coated with the fluorescent powder which can generate blue lights under the excitation energy; and the third transparent matrix unit is not coated with the fluorescent powders when the backlight module comprises a blue light LED (light emitting diode). *"*A General Strategy for Biocompatible, High-Effective Upconversion Nanocapsules based on Triplet-Triplet Annihilation" to Liu et al in Journal Of The American Chemical Society (2013), vol.135, No. 13, pp. 5029-5037 discloses a strategy which can maintain high translational mobility of chromophores, avoid luminescence quenching of chromophores by aggregation, and decrease the O₂-induced quenching of TTA-based upconversion emission.

### SUMMARY OF THE INVENTION

The invention is set out in accordance with the appended claims. The present invention provides a novel light emitting apparatus comprising a blue backlight unit and a color conversion array comprising at least red, green, and blue pixels. Nanoparticles with narrow band width (for example, a full width half maximum, or FWHM, of the emission band of less than 100 nanometers) are employed in the color conversion array to replace incumbent light absorbing materials in conventional color filter arrays. The nanoparticles are excited by a uniform blue backlight which is modulated by a liquid crystal component. Nanoparticles that absorb the blue light and generate green light may be located in the green pixel. Nanoparticles that absorb the blue light and generate red light may be located in the red pixel. For the blue pixel area, light may directly come from the blue backlight unit. In one embodiment, this novel light emitting apparatus produces a high quality color via a combination of high purity R, G, and B colors. More importantly, such design could potentially lead to nearly 50% of power consumption reduction, relative to conventional color filter arrays. Furthermore, since only blue light is used in the backlight unit, it simplifies the controlling system of the liquid crystal component.

In a first aspect, the present invention provides a light emitting apparatus comprising:
a backlight unit that emits blue light, and
a color conversion array receiving the blue light from the backlight unit;
wherein the color conversion array comprises a green color conversion layer and a red color conversion layer,
wherein at least one of the green color conversion layer and the red color conversion layer comprises first or second nanoparticles that emit green or red light respectively, and said first or second nanoparticles are encapsulated organic light emitting compounds where the organic light emitting compound has an absorption of at least 1000 M⁻¹ cm⁻¹ in a spectral region of 430-500 nanometers (nm) and exhibits a full width half maximum of the emission band of less than 100 nm;
wherein the color conversion array comprises a green color conversion layer comprising the first nanoparticles, and a red color conversion layer comprising the second nanoparticles;
wherein the first nanoparticles comprise encapsulated organic emitting compounds and the organic light emitting compounds have the structure of formula (I): 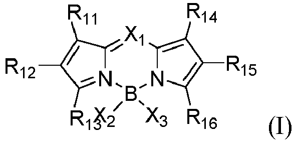
wherein R₁₁ through R₁₆ are each independently selected from H, a halogen, -CN,-CF₃, -NO₂, a substituted or unsubstituted C₁-C₂₄ alkyl, a substituted or unsubstituted C₂-C₂₄ alkenyl, a substituted or unsubstituted C₂-C₂₄ alkynyl, a substituted or unsubstituted C₁-C₂₄ alkoxy, a substituted or unsubstituted C₃-C₂₀ cyclic or heterocyclic group, -SO₃H, sulfonate,-SO₂O-, a thio ether, an ether, a urea, -CO₂H, an ester, an amide, an amine, a C₆-C₂₀ substituted or unsubstituted aromatic group, or a C₅-C₂₀ substituted or unsubstituted heteroaromatic group; R₁₁ and R₁₂ may join together to form a 5-, 6-, 7-membered ring together with the atoms they are bonded; R₁₂ and R₁₃ may join together to form a 5-, 6-, 7-membered ring together with the atoms they are bonded; R₁₄ and R₁₅ may join together to form a 5-, 6-, 7-membered ring together with the atoms they are bonded; and R₁₅ and R₁₆ may join together to form a 5-, 6-, 7-membered ring together with the atoms they are bonded;
wherein X₁ is N or CR₁₇, wherein R₁₇ is selected from H, a halogen, -CN, -CF₃, a substituted or unsubstituted C₁-C₂₄ alkyl, a substituted or unsubstituted C₂-C₂₄ alkenyl, a substituted or unsubstituted C₂-C₂₄ alkynyl, a substituted or unsubstituted C₁-C₂₄ alkoxy, a substituted or unsubstituted C₃-C₂₀ cyclic or heterocyclic group, a substituted or unsubstituted C₆-C₂₀ aromatic group, a substituted or unsubstituted C₅-C₂₀ heteroaromatic group, an ether, an ester, a carboxylic acid, -OH, an amide, an amine, or a sulfide; and
wherein X₂ and X₃ are each independently selected from a halogen, a substituted or unsubstituted C₁-C₂₄ alkyl, a substituted or unsubstituted C₂-C₂₄ alkenyl, a substituted or unsubstituted C₂-C₂₄ alkyne, a substituted or unsubstituted C₃-C₂₀ cyclic or heterocyclic group, a C₆-C₂₀ substituted or unsubstituted aromatic group, a substituted or unsubstituted C₅-C₂₀ heteroaromatic group, or a substituted or unsubstituted C₁-C₂₄ alkoxy; and X₂ and X₃ may join together to form a single substituent group; and
wherein the second nanoparticles comprise encapsulated organic light emitting compounds and the organic light emitting compounds are selected from perylenediimide, boron-dipyrromethene, diketopyrrolopyrrol, 4-dicyanomethylene-2-*t*-*butyl*-6-1,1,7,7-tetramethyljulolidyl-9-enyl-4*H*-pyran, coumarin, rhodamine, fluorescein, and cyanine.

In a second aspect, the present invention provides an electronic device comprising the light emitting apparatus of the first aspect.

### BRIEF DESCRIPTION OF THE DRAWINGS

Figure 1a, Figure 1b, and Figure 1c are each a schematic perspective view of one embodiment of a light emitting apparatus of the present invention.
Figure 2a, Figure 2b, and Figure 2c are each a cross-section of a color conversion array in one embodiment of a light emitting apparatus of the present invention.
Figure 3 is a Scanning Transmission Electron Microscopy (STEM) image of the first nanoparticles.
Figure 4 is a STEM image of the second nanoparticles.

### DETAILED DESCRIPTION OF THE INVENTION

A "luminophore" refers to an atom or functional group in a chemical compound that is responsible for its luminescent properties when exposed to electromagnetic radiation. Luminophore may be referred to herein as light-emitting groups and vice-versa.

An "electronic device" refers to a device which depends on the principles of electronics and uses the manipulation of electron flow for its operation.

An "alkyl" refers to an acyclic saturated monovalent hydrocarbon group and includes linear and branched groups with hydrogen unsubstituted or substituted by a halogen, a hydroxyl, a cyano, a sulfo, a nitro, an alkyl, a perfluoroalkyl, or combinations thereof.

A "heteroalkyl" refers to a saturated hydrocarbon group having a linear or branched structure wherein one or more of the carbon atoms within the alkyl group has been replaced with a heteroatom or a heterofunctional group containing at least one heteroatom. Heteroatoms may include, for example, O, N, P, S and the like. The heterofunctional group containing at least one heteroatom herein may include, for example, COOR', OCOOR', OR', NR'₂, PR'₂, P(=O)R'₂, or SiR'₃; where each R' is H, a substituted or unsubstituted C₁-C₃₀ hydrocarbyl group, or a substituted or unsubstituted C₆-C₃₀ aromatic group.

An "alkenyl" refers an unsaturated hydrocarbon that contains at least one carbon-carbon double bond. A substituted alkenyl refers to an alkenyl wherein at least one of the hydrogens on the carbon double bond is replaced by an atom or group other than H, for example, a C₁-C₃₀ alkyl group or C₆-C₃₀ aromatic group. An "alkynyl" refers to an unsaturated hydrocarbon containing at least one carbon-carbon triple bond. A substituted alkenyl refers to an alkenyl wherein at least one of the hydrogens on the carbon double bond is replaced by an atom or group other than H, for example, a C₁-C₃₀ alkyl group or C₆-C₃₀ aromatic group. In case that an alkenyl or alkynyl group contains more than one unsaturated bonds, these bonds usually are not cumulated, but may be arranged in an alternating order, such as in - [CH=CH-]ₚ, where p may be in the range of 2-50. Where not defined otherwise, preferred alkyl contains 1-22 carbon atoms; preferred alkenyl and alkynyl contain 2-22 carbon atoms.

An "alkoxy" refers to an alkyl group singular bonded with oxygen. Alkoxy such as C₁-C₂₄ alkoxy is a straight-chain or branched radical, for example, methoxy, ethoxy, isopropoxy, n-butoxy, sec-butoxy, tert-butoxy, heptyloxy, octyloxy, isooctyloxy, nonyloxy, decyloxy, undecyloxy, dodecyloxy, tetradecyloxy, hexadecyloxy, and octadecyloxy. A substituted alkoxy refers to a substituted alkyl group singular bonded with oxygen.

An "aliphatic cyclic group" refers to an organic group that is both aliphatic and cyclic. The aliphatic cyclic group contains one or more carbon rings that can be either saturated or unsaturated. A substituted aliphatic cyclic group may have one or more side chains attached where the side chain can be a substituted or unsubstituted alkyl, a substituted or unsubstituted heteroalkyl, a substituted or unsubstituted alkenyl, a substituted or unsubstituted alkynyl, or a substituted or unsubstituted alkoxy. Examples of aliphatic cyclic groups include cyclobutyl, cyclopentyl, cyclohexyl, methylcyclohexyl, dimethylcyclohexyl, trimethylcyclohexyl, 1-adamantyl, and 2-adamantyl.

A "heterocyclic group" refers to a cyclic compound that has atoms of at least two different elements as members of its ring(s). A heterocyclic group usually contains 5 to 7 ring members, among them, at least 1, especially 1-3, heteromoieties, usually selected from O, S, NR'. Examples include C₄-C₁₈ cycloalkyl, which is interrupted by O, S, or NR', such as piperidyl, tetrahydrofuranyl, piperazinyl, and morpholinyl. Unsaturated variants may be derived from these structures, by abstraction of a hydrogen atom on adjacent ring members with formation of a double bond between them; an example for such a moiety is cyclohexenyl. A substituted heterocyclic group may have one or more side chains attached, where the side chain can be substituted or unsubstituted alkyl, substituted or unsubstituted heteroalkyl, substituted or unsubstituted alkenyl, substituted or unsubstituted alkynyl, substituted or unsubstituted alkoxy, or another heterocyclic group either directed linked together or via linking groups.

An "aromatic group" refers to a hydrocarbon with sigma bonds and delocalized pi electrons between carbon atoms forming rings, usually the benzene-based, or aryl groups. Aryl is defined as an aromatic or polyaromatic substituent containing 1 to 4 aromatic rings (each ring containing 6 conjugated carbon atoms and no heteroatoms) that are optionally fused to each other or bonded to each other by carbon-carbon single bonds. A substituted aromatic or aryl group refers to an aryl ring with one or more substituents replacing the hydrogen atoms on the ring. The aryl group is unsubstituted or optionally and independently substituted by any synthetically accessible and chemically stable combination of substituents that are independently a halogen, a cyano, a sulfo, a carboxy, an alkyl, a perfluoroalkyl, an alkoxy, an alkylthio, an amino, a monoalkylamino, or a dialkylamino. Examples include substituted or unsubstituted derivatives of phenyl; biphenyl; o-, m-, or p- terphenyl; 1-naphthal; 2-naphthal; 1-, 2-, or 9-anthryl; 1-, 2-, 3-, 4-, or 9-phenanthrenyl and 1-, 2-, or 4-pyrenyl. Preferable aromatic or aryl groups are phenyl, substituted phenyl, naphthyl or substituted naphthyl.

A "heteroaromatic group" or a "heteroaryl group" refers to a 5- or 6-membered heteroaromatic ring that is optionally fused to an additional 6-membered aromatic ring(s), or is optionally fused to a 5- or 6-membered heteroaromatic rings. The heteroaromatic rings contain at least 1 and as many as 3 heteroatoms that are selected from the group consisting of O, S or N in any combination. A substituted heteroaromatic or heteroaryl group refers to a heteroaromatic or heteroaryl ring with one or more substituents replacing the hydrogen atoms on the ring. The heteroaromatic or heteroaryl group is unsubstituted or optionally and independently substituted by any synthetically accessible and chemically stable combination of substituents that are independently a halogen, a cyano, a sulfo, a carboxy, an alkyl, a perfluoroalkyl, an alkoxy, an alkylthio, an amino, a monoalkylamino, or a dialkylamino. Examples include substituted or unsubstituted derivatives of 2- or 3-furanyl; 2- or 3-thienyl; N-, 2- or 3-pyrroyl; 2- or 3-benzofuranyl; 2- or 3-benzothienyl; N-, 2-, or 3-indolyl; 2-, 3-, or 4-pyridyl; 2-, 3-, or 4-quinolyl; 1-, 3-, or 4-isoquinlyl; 2-benzoxazolyl; 2-, 4-, or 5-(1,3-oxazolyl); 2-, 4-, or 5-(1,3-thiazolyl); 2-benzothiazolyl; 3-, 4-, or 5-isoxazolyl; N-, 2-, or 4-imidazolyl; N-, or 2-benimidazolyl; 1-, or 2-naphthofuranyl; 1-, or 2-naphthothieyl; N-, 2- or 3-benzindolyl; or 2-, 3-, or 4-benzoquinolyl.

The "quantum yield" of a luminophore is the ratio of the number of emitted photons to the number of photons absorbed.

An "excited state" is an electronic state of a molecule in which the electrons populate an energy state that is higher than another energy state for the molecule.

The light emitting apparatus of the present invention comprises a backlight unit that emits blue light for color conversion layers. A common source for the blue light is an LED lamp. Another blue light source is an organic light emitting device (OLED). These blue light sources must provide homogeneous light to the back surface of the color conversion layer. A common technique for providing such a homogeneous blue light is to optically couple the light source to the edge of a clear plastic sheet often called light guide. The light guide can bend the light approximately normal to the top surface of the sheet so that light is emitted from the front surface of the light guide. A reflector may be placed behind the back surface of the light guide to improve brightness and uniformity. The light source can also be placed behind the display with diffusers to uniformly distribute the light across the displays. The wavelength of the light from the backlight unit may be from 430 to 500 nm, from 444 to 495 nm, or from 450 to 475 nm. The intensity of the backlight may be adjusted depending on the end application.

The light emitting apparatus of the present invention further comprises a color conversion array receiving the blue light from the backlight unit. The color conversion array useful in the present invention can allow at least a portion of the blue light of the backlight unit to pass through so that at least red, green, and blue light are emitted by the light emitting apparatus to create colors comprising red, green, and blue components. The color conversion array comprises a green color conversion layer and a red color conversion layer, where at least one of the green color conversion layer and the red color conversion layer comprises first or second nanoparticles that emit green or red light respectively. That is, the first or second nanoparticles convert the blue light from the backlight unit to green or red colors respectively. The nanoparticles in the green color conversion layer are first nanoparticles that convert light from the backlight unit to green light. The nanoparticles in the red color conversion layer are second nanoparticles that convert light from the backlight unit to red light. In one embodiment, the color conversion array comprises a green color conversion layer comprising the first nanoparticles that convert the blue light from the backlight unit to green light, and a red color conversion layer comprising organic red light emitting compounds, inorganic phosphors, quantum dots, or mixtures thereof. In another embodiment, the color conversion array comprises a red color conversion layer comprising the second nanoparticles that convert the blue light from the backlight unit to red light, and a green color conversion layer comprising organic green light emitting compounds, inorganic phosphors, quantum dots, or mixtures thereof.

In a further embodiment, the color conversion array useful in the light emitting apparatus comprises both a green color conversion layer comprising the first nanoparticles that converts the blue light from the backlight unit to green light, and a red color conversion layer comprising second nanoparticles that convert the blue light from the backlight unit to red light. The color conversion array useful in the present invention allows at least a portion of the blue light of the backlight unit to pass through so that the red, green, and blue light are emitted by the light emitting apparatus to create colors with red, green, and blue components. For example, the color conversion array may allow up to 30%, up to 25%, up to 20%, up to 15%, up to 10%, or up to 5% of the blue light of the backlight unit to pass through.

The first and second nanoparticles useful in the color conversion array may be each independently encapsulated organic light emitting compounds. The organic light emitting compounds may include organic and metal-organic complex light emitting compounds. Examples of metal-organic complex light emitting compounds include transition metal complexes, such as tris(2-phenylpyridinyl) iridium. The organic light emitting compound may exhibit a full width half maximum (FWHM) of the emission band of less than 100 nm and has an absorption of at least 1000 M⁻¹ cm⁻¹ in a spectral region of 430-500 nm. Preferably, the organic light emitting compound exhibits a FWHM of the emission band of less than 100 nm, less than 90 nm, less than 70 nm, or even less than 50 nm.

The organic light emitting compound useful for preparing the first nanoparticles has the structure of formula (I): 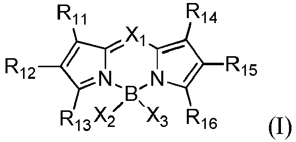 wherein R₁₁ through R₁₆ are each independently selected from H, a halogen, -CN,-CF₃, -NO₂, a substituted or unsubstituted C₁-C₂₄ alkyl, a substituted or unsubstituted C₂-C₂₄ alkenyl, a substituted or unsubstituted C₂-C₂₄alkynyl, a substituted or unsubstituted C₁-C₂₄ alkoxy, a substituted or unsubstituted C₃-C₂₀ cyclic or heterocyclic group, -SO₃H, sulfonate,-SO₂O-, a thio ether, an ether, a urea, -CO₂H, an ester, an amide, an amine, a substituted or unsubstituted C₆-C₂₀ aromatic group, or a substituted or unsubstituted C₅-C₂₀ heteroaromatic group; R₁₁ and R₁₂ may join together to form a 5-, 6-, 7-membered ring together with the atoms they are bonded; R₁₂ and R₁₃ may join together to form a 5-, 6-, 7-membered ring together with the atoms they are bonded; R₁₄ and R₁₅ may join together to form a 5-, 6-, 7-membered ring together with the atoms they are bonded; and R₁₅ and R₁₆ may join together to form a 5-, 6-, 7-membered ring together with the atoms they are bonded, that may be substituted or unsubstituted;
wherein X₁ is N or CR₁₇, wherein R₁₇ is selected from H, a halogen, -CN, -CF₃, a substituted or unsubstituted C₁-C₂₄ alkyl, a substituted or unsubstituted C₂-C₂₄ alkenyl, a substituted or unsubstituted C₂-C₂₄ alkynyl, a substituted or unsubstituted C₁-C₂₄ alkoxy, a substituted or unsubstituted C₃-C₂₀ cyclic or heterocyclic group, a substituted or unsubstituted C₆-C₂₀ aromatic group, a substituted or unsubstituted C₅-C₂₀ heteroaromatic group, an ether, an ester, a carboxylic acid, -OH, an amide, an amine, or a sulfide; and
wherein X₂ and X₃ are each independently selected from a halogen, a substituted or unsubstituted C₁-C₂₄ alkyl, a substituted or unsubstituted C₂-C₂₄ alkenyl, a substituted or unsubstituted C₂-C₂₄ alkyne, a substituted or unsubstituted C₃-C₂₀ cyclic or heterocyclic group, a C₆-C₂₀ substituted or unsubstituted aromatic group, a substituted or unsubstituted C₅-C₂₀ heteroaromatic group, or a substituted or unsubstituted C₁-C₂₄ alkoxy; and X₂ and X₃ may join together to form a single substituent group.

Preferably, R₁₁ through R₁₆ in formula (I) are each independently selected from H, -CN, -COOH, -OH, a halogen, methyl, ethyl, propyl isopropyl, perfluoromethyl, phenyl, a substituted phenyl, naphthyl, a substituted naphthyl, methoxy, ethoxy, styryl, pyridyl, substituted pyridyl, thienyl, a substituted thienyl, pyrrolyl, a substituted pyrrolyl, ester, sulfonate, nitro, amine, an amide, or combinations thereof.

Preferably, R₁₂ and R₁₅ in formula (I) are each independently electron-withdrawing groups selected from trihalides, amides, esters, ammoniums, quaternary amines, quanternary ammonium bases, sulfonates, -SO₃H, -CN, or -NO₂. More preferably, R₁₂ and R₁₅ in formula (I) are each independently selected from the following structure: -CN, -NO₂, esters, amides, trifluoromethyl, and sulfonates.

Preferably, X₁ in formula (I) is CR₁₇, wherein R₁₇ is selected from H, -CN, methyl, ethyl, phenyl, a substituted phenyl, naphthyl, a substituted naphthyl, a substituted or unsubstituted C₁-C₃ alkyl, a substituted or unsubstituted C₁-C₄ alkenyl, thiol, a hetercyclic group, or a heteroaromatic group. More preferably, R₁₇ is methyl. Also preferably, R₁₇ is a substituted or unsubstituted C₆-C₁₀ aromatic group, for example, phenyl or a substituted phenyl.

X₂ and X₃ in formula (I) can be each independently selected from F, methyl, ethyl, n-propyl, iso-propyl, n-butyl, adamantyl, a substituted or unsubstituted phenyl, a C₁-C₆ alkyoxy such as methoxy, a substituted or unsubstituted ethynyl such as ethynyltoluene, ethynylpyrene, and ethynylphenyl. Preferably, X₂ and X₃ are each F.

In one embodiment, the light emitting compound useful for preparing the second nanoparticles may have the structure of formula (II): 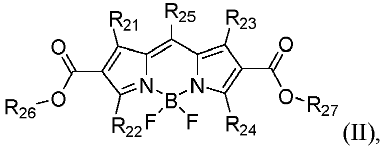 wherein R₂₁ through R₂₅ are each independently selected from H, a halogen, -CN, - CF₃, -NO₂, a substituted or unsubstituted C₁-C₂₄ alkyl, a substituted or unsubstituted C₂-C₂₄ alkenyl, a substituted or unsubstituted C₂-C₂₄ alkynyl, a substituted or unsubstituted C₁-C₂₄ alkoxy, a substituted or unsubstituted C₃-C₂₀ cyclic or heterocyclic group, -SO₃H, sulfonate,-SO₂O-, a thio ether, an ether, a urea, -CO₂H, an ester, an amide, an amine, a substituted or unsubstituted C₆-C₂₀ aromatic group, or a substituted or unsubstituted C₅-C₂₀ heteroaromatic group; and
R₂₆ and R₂₇ are each independently selected from a substituted or unsubstituted C₁-C₂₀ alkyl, a C₂-C₂₀ substituted or unsubstituted alkenyl, a substituted or unsubstituted C₂-C₂₄ alkynyl, a substituted or unsubstituted C₁-C₂₄ alkoxy, a substituted or unsubstituted C₆-C₂₄ aryl group; a substituted or unsubstituted C₃-C₂₀ cyclic or heterocyclic group, or a substituted or unsubstituted C₅-C₂₀ heteroaromatic group.

The substituted or unsubstituted C₁-C₂₄ alkyl in formula (I) or (II) above may include a substituted or unsubstituted C₁-C₂₂, C₁-C₁₆, C₁-C₁₂, or C₁-C₅ alkyl. Examples of alkyls include methyl, ethyl, propyl, iso-propyl, butyl, iso-butyl, tert-butyl pentyl, hexyl, heptyl, octyl, or combinations thereof.

The substituted or unsubstituted C₂-C₂₄ alkenyl in formula (I) or (II) above may include a C₂-C₂₂, C₂-C₁₆, C₂-C₁₂, or C₂-C₅ substituted or unsubstituted alkenyl. Examples of substituted or unsubstituted alkenyls include ethylene; n-propylene; i-propylene; n-, i-, sec, tert- butylene; n-pentylene; n-hexylene; n-heptylene; n-octylene; or combinations thereof.

The substituted or unsubstituted C₂-C₂₄ alkynyl in formula (I) or (II) above may include a substituted or unsubstituted C₂-C₂₀, C₂-C₁₆, C₂-C₅, or C₂-C₃ alkynyl. Examples of substituted or unsubstituted alkynyl include ethynyl, propynyl, phenylethylnyl, or combinations thereof.

The substituted or unsubstituted C₁-C₂₄ alkoxy in formula (I) or (II) above may include a substituted or unsubstituted C₁-C₂₀, C₁-C₁₆, C₁-C₁₂, or C₁-C₅ alkoxy. Examples of substituted or unsubstituted alkoxys include methoxy; ethoxy; n-, i-propoxy; n-, i-, sec-, tert-butoxy; n-penyoxy; n-hexoxy; n-heptoxy; n-octoxy; or combinations thereof.

The substituted or unsubstituted C₃-C₂₀ cyclic or heterocyclic group in formula (I) or (II) above may include a substituted or unsubstituted C₃-C₁₈, C₆-C₁₄, or C₆-C₈ cyclic or heterocyclic group. Examples of substituted or unsubstituted cyclic or heterocyclic groups include cyclopropyl, cyclobutyl, cyclopentyl, methylcyclopentyl, cyclohexyl, methylcyclohexyl, dimethylcyclohexyl, cycloheptyl, cyclooctyl, cyclononyl, cyclodecyl, 1-adamantyl, 2-adamantyl, piperdyl, tetrahydrofuran, piperazinyl, morpholinyl, cyclopentyloxy, cyclohexyloxy, cycloheptyloxy, cyclooctyloxy or mixtures thereof. Unsaturated variants may be derived from these structures by substraction of a hydrogen atom on 2 adjacent ring members with formation of a double bond between them, an example for such a moiety is cyclohexenyl.

The substituted or unsubstituted C₆-C₃₀ aromatic group in formula (I) or (II) above may include a substituted or unsubstituted C₆-C₂₀, C₆-C₁₈, C₆-C₁₄, or C₆-C₁₀ aromatic group. Examples include phenyl; biphenyl; o-, m-, or p-terphnyl; 1-naphthyl; 2-naphthyl; 1-, 2-, or 9-anthryl; 1, 2, 3, 4, or 9-phenanthrenyl; 1, 2, or 4-pyrenyl; or combinations thereof.

The substituted or unsubstituted C₅-C₃₀ heteroaromatic group in formula (I) or (II) above may include a substituted or unsubstituted C₅-C₂₀, C₅-C₁₆, C₅-C₁₂, or C₅-C₈ heteroaromatic group. Examples include 2- or 3-furanyl; 2- or 3-thienyl; N-, 2- or 3-pyrroyl; 2- or 3-benzofuranyl; 2- or 3-benzothienyl; N-, 2-, or 3-indolyl; 2-, 3-, or 4-pyridyl; 2-, 3-, or 4-quinolyl; 1-, 3-, or 4-isoquinlyl; 2-benzoxazolyl; 2-, 4-, or 5-(1,3-oxazolyl); 2-, 4-, or 5-(1,3-thiazolyl); 2-benzothiazolyl; 3-, 4-, or 5-isoxazolyl; N-, 2-, or 4-imidazolyl; N-, or 2-benimidazolyl; 1-, or 2-naphthofuranyl;1-, or 2-naphthothieyl; N-, 2- or 3-benzindolyl; 2-, 3-, or 4-benzoquinolyl; or combinations thereof.

Examples of suitable organic light emitting compounds for preparing the first nanoparticles in the present invention include, 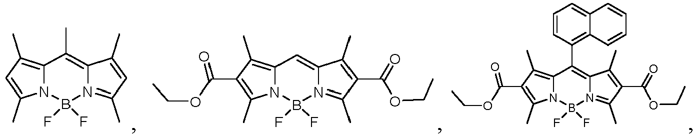 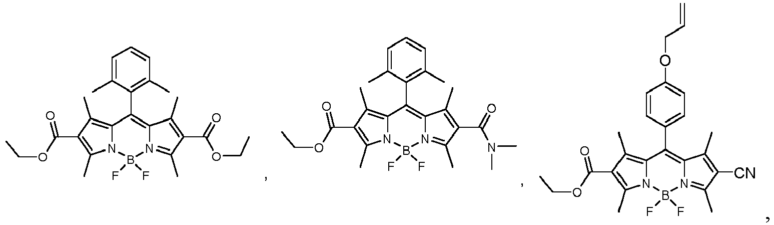 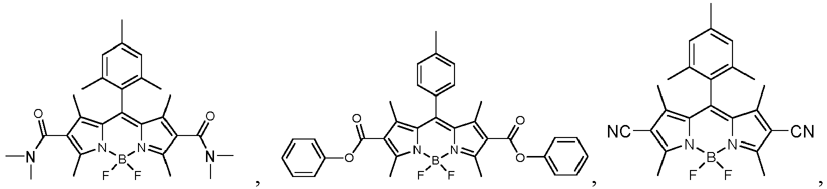 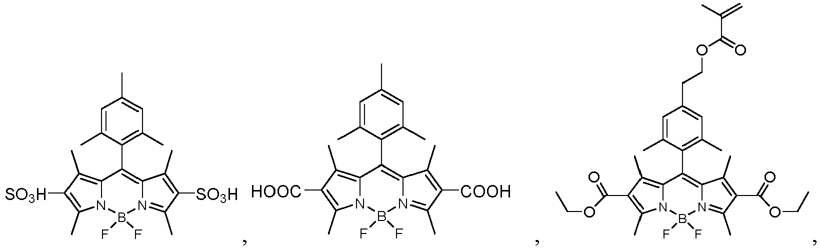 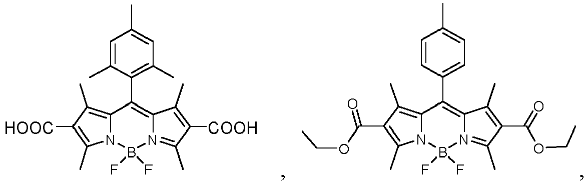 or mixtures thereof.

The organic light emitting compounds useful for preparing the second nanoparticles are selected from perylenediimide, boron-dipyrromethene, diketopyrrolopyrrol, 4-dicyanomethylene-2-*t*-*butyl*-6-1,1,7,7-tetramethyljulolidyl-9-enyl-4*H-*pyran, coumarin, rhodamine, fluorescein, and cyanine. Examples of suitable organic light emitting compounds for preparing the second nanoparticles in the present invention include, 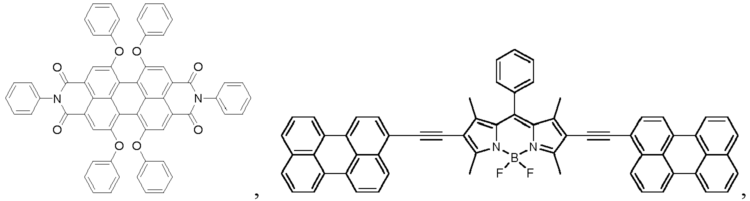 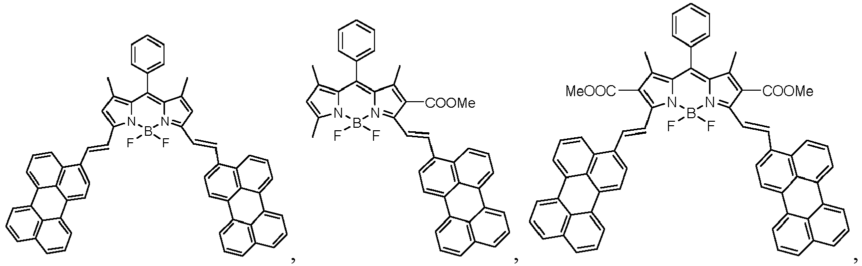 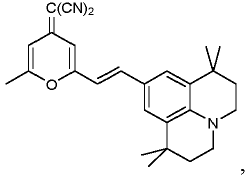 or mixtures thereof.

In one embodiment, the first and second nanoparticles useful in the color conversion array may each comprise a silica containing core covalently bonded with a luminophore derived from the organic light emitting compound described above and a shell at least partially encapsulating the core. "Covalently bonded" herein refers to at least one chemical bond being formed between the silica containing core and the luminophore derived from the organic light emitting compound.

In another embodiment, the first and second nanoparticles useful in the color conversion array may comprise a core and a shell. The core may comprise a reaction product of a functionalized light emitting compound and a first precursor. The shell may encapsulate or at least partially encapsulate the core and may comprise the reaction product of a second precursor. The core of the first and second nanoparticles may each independently comprise a reaction product of two or more functionalized light emitting compounds and the first precursor in order to achieve a desirable blend output of spectral emission colors.

Preferably, the first and second nanoparticles useful in the color conversion array may each independently comprise:
a core comprising a reaction product of the functionalized organic light emitting compound and the first precursor, wherein the functionalized organic light emitting compound has the structure of D-L-SiX₃, wherein D is a luminophore derived from the organic light emitting compound, L is a direct bond or an organic group, and X is a hydrolyzable substituent; and the first precursor is selected from (a) a first organic silane compound having the structure of SiX¹₄, (b) a first organic metal compound having the structure of MX¹₃ or MX¹₄, or mixtures thereof; wherein each X¹ is independently a hydrolyzable substituent, and M is selected from Al, Zr, Ti, or combinations thereof; and
a shell comprising a reaction product of a second precursor, wherein the second precursor is selected from (a) a second organic silane compound having the structure of SiX²₄, (b) a second organic metal compound having the structure of MX²₃ or MX²₄, or mixtures thereof; wherein each X² is independently a hydrolyzable substituent, and M is selected from Al, Zr, Ti, or combinations thereof. The reaction product of the second precursor refers to a product obtained through hydrolysis and condensation of the second precursor.

Preferably, the first and second nanoparticles each independently comprise: a core comprising a reaction product of the functionalized organic light emitting compound and the first precursor selected from the first organic silane compound, and a shell comprising a reaction product of a second precursor selected from the second organic silane compound.

The functionalized light emitting compound useful in preparing the first and second nanoparticles may have the structure of formula (III):

D-L-S₁X₃ (III)

wherein D is a luminophore, L is a direct bond or an organic group, and X is a hydrolyzable substituent. A mixture of two or more types of the functionalized light emitting compounds may be used.

L in formula (III) can comprise a divalent, a trivalent, a tetravalent or a pentavalent moiety. For example, L can be an substituted or unsubstituted alkyl, such as a substituted or unsubstituted C₁-C₁₂, C₁-C₈, or C₁-C₄ alkyl; an substituted or unsubstituted alkoxy, such as a substituted or unsubstituted C₁-C₁₂, C₁-C₈, or C₁-C₄ alkoxy; a substituted or unsubstituted alkenyl group, such as a substituted or unsubstituted C₂-C₁₂, C₂-C₈, or C₂-C₄ alkenyl group; an substituted or unsubstituted alkynyl group, such as a substituted or unsubstituted C₂-C₁₂, C₂-C₈, or C₂-C₄ alkynyl group; a substituted or unsubstituted aliphatic cyclic group, such as a substituted or unsubstituted C₃-C₂₀, C₅-C₁₀, or C₅-C₆ aliphatic cyclic group; an substituted or unsubstituted heterocyclic group, such as a substituted or unsubstituted C₃-C₂₀, C₅-C₁₀, or C₅-C₆ heterocyclic group; an substituted or unsubstituted aromatic group, such as a substituted or unsubstituted C₆-C₂₀, C₆-C₁₄, or C₆-C₁₀ aromatic group; an substituted or unsubstituted heteroaromatic group, such as a substituted or unsubstituted C₅-C₂₀, C₅-C₁₄, or C₅-C₆ heteroaromatic group; an ether, an ester, a urethane, a sulfide, an amide, or an amine. Preferably, L is selected from a C₁-C₈ substituted or unsubstituted alkyl or a C₁-C₁₀ substituted or unsubstituted alkoxy.

X in formula (III) is a hydrolyzable substituent. "Hydrolyzable substituent" in the present invention refers to a functional group which undergoes breakage of chemical bond by the addition of water, optionally in the presence of a catalyst. Examples of suitable X include a substituted or unsubstituted C₁-C₁₈ alkoxy, and preferably a substituted or unsubstituted C₁-C₄ alkoxy. More preferably, X is selected from a methoxy, ethoxy or 2-methoxy-ethoxy. X can also be a -OH group.

D in formula (III) refers to a group derived from the organic light emitting compound, or a luminophore. A luminophore can be further classified as a singlet luminophore (fluorophore) or a triplet luminophore (phosphor), depending on the nature of the excited state responsible for the emission of photons. On the other hand, some luminophores can't be classified as exclusively singlet luminophore or triplet luminophore. Most fluorophores consists of conjugated pi systems. A typical luminophore is an aromatic or heteroaromatic compound such as a pyrene, an anthracene, an acridine, a stilbene, an indole or benzoindole, a porphyrin, a perylene, a cyanine, a coumarin, naphthalimide, rhodamine, fluoresceine, xanthenes, benzoxanthene, diketopyrrolopyrrole, and the like.

The functionalized light emitting compound useful in preparing the first and second nanoparticles may be prepared by known processes, in which the light emitting compound described above is attached with one or more than one reactive group, such as an allyl group, forming the reactive light emitting compound which then reacts with a reactive organic silane compound to form the functionalized light emitting compound. The reactive organic silane compound useful in forming the functionalized light emitting compound has at least one functional group which can react with the reactive group of the reactive light emitting compound to form a covalent bond, for example, -Si-C-. The reactive organic silane compound has the general formula R₍₄₋ₙ₎SiXₙ, where X is a hydrolyzable substituent as described above in the functionalized light emitting compound section, such as ethoxy, methoxy, or 2-methoxy-ethoxy; R can be H, a monovalent organic group having from 1 to 12 carbon atoms which can optionally contain a functional organic group such as, for example, mercapto, epoxy, acrylyl, methacrylyl, and amino; and n is an integer of from 1 to 4, preferably an integer from 2 to 4. Examples of suitable reactive organic silane compounds include tetramethoxysilane (TMOS), tetraethoxysilane (TEOS), methyltrimethoxysilane (MTMS), methyltriethoxysilane (MTES), HSi(OEt)₃, or mixtures thereof. In one embodiment, the reactive organic silane compound is HSi(OEt)₃.

The first precursor useful in preparing the first and second nanoparticles may be selected from a first organic silane compound having the structure of SiX¹₄, a first organic metal compound of MX¹₄ or MX¹₃ or mixtures thereof; wherein X¹ may be the same or different and each independently a hydrolyzable substituent, and M is selected from Al, Zr, Ti, or combinations thereof. X¹ may include those groups described above for X in formula (III), and preferably X¹ is a C₁-C₁₈ alkoxy.

The first organic silane compound useful in preparing the first and second nanoparticles can form silica under hydrolysis conditions. Examples of suitable first organic silane compounds include substituted or unsubstituted tetra-Ci-Cs alkoxysilanes such as tetramethoxysilane (TMOS), tetraethoxysilane (TEOS), tetra-n-propoxysilane, and tetra-n-butoxysilane; tetrakis(methoxyethoxy)silane; tetrakis(ethoxyethoxy)silane; tetrakis(methoxyethoxyethoxy)silane; tetrakis(methoxypropoxy)silane; tetrakis(2-methylhexoxy)silane; di-C₁-C₄ alkyl-tetra-C₁-C₈ alkoxydisilanes such as dimethyltetraethoxydisiloxane; tetra-C₁-C₄ acyloxysilanes such as tetraacetoxysilane; tetra-C₂-C₄ alkenyloxysilanes such as tetraallyloxysilane; mixtures thereof. The first organic silane compound is preferably TEOS, TMOS, or a mixture thereof.

Under hydrolysis conditions, the first organic metal compound can form Al₂O₃, ZrO₂, or TiO₂. Examples of suitable first organic metal compounds include tri-C₁-C₄ alkoxy aluminate like tri-n-, -i-propoxy aluminate, tri-n-butoxyaluminate, like di-C₁-C₄ alkoxy aluminoxy tri-C₁-C₄ alkoxy silanes such as dibutoxy-aluminoxy-triethoxy-silane; tetra-n-butoxy zirconate, tetraethoxy zirconate, and tetra-n-, -i-propoxy zirconate; tetra-C₁-C₄ alkoxy zirconate such as tetra-n-butyl titanate, tetraethoxy titanate, tetramethoxy titanate, and tetra-n-, -i-propoxy titanate; or mixtures thereof.

The first precursor useful in preparing the first and second nanoparticles can be a mixture of one or more first organic silane compounds and one or more first organic metal compounds. In such mixture, the molar ratio of the first organic silane compound to the first organic metal compound in the first precursor may be from 0.001:1 to 1000:1, from 0.01:1 to 100:1, from 0.1:1 to 100:1, or from 1:1 to 100:1. Preferably, the first precursor comprises TEOS and an organic zirconia. Also preferably, the first precursor comprises TEOS and an organic titanium compound. The molar ratio of the functionalized light emitting compound to the first precursor may be from 0.0001:1 to 0.2:1, from 0.0002:1 to 0.05:1, or from 0.0005:1 to 0.01:1.

Preferably, the second precursor useful in preparing the first and second nanoparticles comprises (a) a second organic silane compound having the structure of SiX²₄ and (b) a second organic metal compound of MX²₄ or MX²₃, wherein each X² is independently a hydrolyzable substituent, and M is selected from Al, Zr, Ti, or combinations thereof. X² may include those groups described for X in formula (I). The second organic silane compound may be the same as or different from the first organic silane compound and may include those useful as the first organic silane compound. The second organic metal compound may be the same or different from the first organic metal compound and may include those useful as the first organic silane compound. Preferably, an organic zirconia, ZrX²₄, such as zirconium n-butoxide is used as the second metal compound. Also preferably, an organic titanium compound, TiX²₄, such as tetrabutyl orthotitanate is used as the second metal compound.

Preferably, the second precursor is a mixture of the second organic silane compound and the second organic metal compound. The molar ratio of the second organic silane compound to the second organic metal compound in the second precursor may be from 0.001:1 to 1000:1, from 0.01:1 to 100:1, from 0.1:1 to 100:1, or from 1:1 to 100:1.

The molar ratio of the first precursor to the second precursor may be from 100:1 to 0.01:1, from 50:1 to 0.1:1, or from 20:1 to 1:1.

The first and second nanoparticles useful in the color conversion array may have a particle size, that is, the diameter of the nanoparticles, in the range of from 10 to 2,000 nm, from 20 to 200 nm, or from 30 to 100 nm. The particle size may be measured by dispersing the nanoparticles into ethanol through a scanning transmission electron microscopy. The first and second nanoparticles preferably have a unimodal distribution. The first and second nanoparticles may have a polydispersity index less than 0.7, less than 0.5, or even less than 0.2, as measured by dynamic light scattering. The first and second nanoparticles may be spherical. The thickness the core to the thickness of the shell can be in a ratio of, for example, from 100:1 to 1:100, from 50:1 to 1:10, or from 20:1 to 5:1.

The first and second nanoparticles useful in the color conversion array can exhibit a FWHM less than 100 nm, less than 90 nm, less than 70 nm, or even less than 50 nm; and have an absorption of at least 1000 M⁻¹ cm⁻¹ in a spectral region of 430-500 nm.

The first and second nanoparticles useful in the color conversion array may be each independently prepared by a process comprising: step (i) providing one or more functionalized light emitting compounds described above; and (ii) adding the first precursor to the functionalized light emitting compound. Usually the first precursor undergoes hydrolysis and co-condenses with the functionalized light emitting compound to form the core of the nanoparticles. This reaction is generally conducted by known sol-gel chemistry, e.g., by hydrolysis of the first organic silane compound and/or the first organic metal compound. The reaction can be carried out in the presence of a solvent. Preferred solvents are organic solvents. Examples of suitable solvents include alcohols such as ethanol, methanol, 1-propanol, 2-propanol, 1-methoxy-2-propanol, or mixtures thereof. In one embodiment, ethanol is used as the solvent. The concentration of the first precursor may be in a range of, based on the volume of the solvent, from 0.05 to 1 mol/L, from 0.1 to 0.8 mol/L, or from 0.1 to 0.5 mol/L. The time duration for such reaction may be in the range of from 1 hour to 48 hours, from 1 hour to 24 hours, or from 2 hours to 12 hours. The core of the nanoparticles may comprise an inorganic matrix obtained by hydrolysis of the first precursor and the luminophore D attached to the inorganic matrix through a covalent bond.

The process useful for preparing the first and second nanoparticles further comprises step (iii) adding the second precursor. The second precursor undergoes hydrolysis and condensation to obtain the nanoparticles. This reaction is generally carried out in the presence of a solvent including those described above useful in the reaction of the first precursor with the functionalized light emitting compound. Preferred solvent is ethanol. Time duration for such reaction may be in the range of from 1 hour to 48 hours, from 1 hour to 24 hours, or from 2 hours to 12 hours. The second precursor is useful in forming the shell of the nanoparticles.

The process for preparing the first and second nanoparticles may be, for the step (ii) and (iii), respectively, conducted at a temperature in the range of 20°C to 100°C, 40°C to 70°C, or 50°C to 60°C.

The process for preparing the first and second nanoparticles may further comprise a surface modification step, that is, (iv) adding a surface modifier having the structure of R¹ₘSi (R²)₄₋ₘ, wherein each R¹ is independently selected from a substituted or unsubstituted C₁-C₂₀ alkyl, a substituted or unsubstituted C₂-C₂₀ alkenyl, or a substituted or unsubstituted C₆-C₂₄ aryl group; each R² is independently a hydrolysable groups; and m is an integer of 1 to 3. For example, each R² is independently selected from a halogen; methoxy; ethoxy; n-, i-propoxy; n-, i-, sec.-, tert.-butoxy; n-pentoxy; n-hexoxy; n-heptoxy; n-octoxy; preferably for C₁-C₄ alkoxy such as for methoxy; ethoxy; n-propoxy; n-butoxy; formyloxy; acetoxy; n-, i-propoyloxy; n-, i-, sec.-, tert.-butoyloxy; n-pentoyloxy; n-hexoyloxy; or acetoxy.

Preferred surface modifiers useful in preparing the first and second nanoparticles include n-C₁-C₁₈ alkyl-tri(C₁-C₈ alkoxy)silanes such as methyltrimethoxysilane (MTMS), methyltriethoxysilane (MTES), ethyl-trimethoxysilane, ethyl-triethoxysilane, n-propyltrimethoxysilan, n-propyl-triethoxysilan, nbutyl-trimethoxysilane, n-octyl-trimethoxysilane, n-octadecyl-trimethoxysilane, n-butyl-triethoxysilane, n-octyltriethoxysilane, n-octadecyltriethoxysilane, NH₂(CH₂)₃Si(OCH₃)₃, CH₂CHCH₂O(CH₂)₃Si(OCH₃)₃, CH₂=C(CH₃)COO(CH₂)₃Si(OCH₃)₃, NH₂(CH₂)₂NH(CH₂)₃Si(OCH₃)₃, HS(CH₂)₃Si(OC₂H₅)₃, NH₂(CH₂)₂NH(CH₂)₃SiCH₃ (OCH₃)₂, CH₂=CHSi(OCH₃)₃, or mixtures thereof. In one embodiment, MTMS or MTES is used as the surface modifier. The dosage of the surface modifier is, based on the weight of the first precursor, in the range of from 5% to 150% by weight, from 10% to 100% by weight, or from 30% to 100% by weight. The step of surface modification may be conducted at a temperature in the range of 20°C to 100°C, 40°C to 80°C, or 50°C to 70°C.

The green color conversion layer in the color conversion array may further comprise a polymeric binder. Examples of suitable polymeric binders are selected from polystyrene, silicone resin, acrylic resin, epoxy resin, or mixtures thereof. It is preferred that the polymer binder is transparent, or at least semi-transparent. In one embodiment, the binder is a photoresist resin comprising a binder resin, a cross-linker, a photo-polymerization initiator, a solvent and additives. The widely used binder resins include a homopolymer or a copolymer of acrylic acid, acrylic ester, acrylic amide, maleic acid, acrylo nitrile, styrene, vinyl acetate, vinylidene chloride and maleimide. Among this, the copolymer including acrylic acid and acrylic ester of a carboxylic group is most preferable. The photo-polymerization initiator may include, for example, ester groups such as 2-hydroxyethylacrylate, ethylglycoldiacrylate, pentaerythritol diacrylate, glycerolacrylate, oxime ester and bisphenol epoxy diacrylate. The solvent may be selected from esters such as ethyl acetate and butyl acetate, ketones such as cyclohexanone and ethyl butyl ketone, alcohol derivatives such as ethylene glycol monoethyl ether acetate and propylene glycol methyl ether acetate, and nitrogen contained groups such as dimethylformamide. These organic solvents may be employed independently or in combination of at least two elements. Finally, the additives such as thermal polymerization inhibitors, plasticizers, auxiliary stabilizers, surface protectors, leveling agents coating agents, or mixtures thereof may be additionally employed in the photoresist resin. In the case when the green color conversion layer comprises the first nanoparticles, the first nanoparticles may be embedded in a film formed by one or more polymeric binders described above. The content of the first nanoparticles in the polymeric binder may be from 0.001% to 80% by weight, from 0.01% to 60% by weight, from 0.1% to 30% by weight, or from 1% to 30% by weight of the total solids weight of the first nanoparticles plus the polymeric binder. In one embodiment, in addition to the first nanoparticles, the green color conversion layer may further comprise other types of green emitting materials such as the organic light emitting compounds as described above that emit green light, inorganic phosphors, or quantum dots.

The red color conversion layer in the color conversion array may further comprise a polymeric binder including those as described in the green color conversion layer. In the case when the red color conversion layer comprises the second nanoparticles, the content of the second nanoparticles in the red color conversion layer may be substantially the same as that of the first nanoparticles in the green color conversion layer described above. In one embodiment, in addition to the second nanoparticles, the red color conversion layer may further comprise other types of red emitting materials such as the organic light emitting compounds as described above that emit red light, inorganic phosphors, or quantum dots. The red color conversion layer may be formed by the same process as described in forming the green color conversion layer.

The color conversion array useful in the present invention may further comprise one or more blue light blocking layers comprising one or more than one blue light absorption materials. The blue light blocking layer may be placed on top of the red color conversion layer and/or the green color conversion layer away from the backlight unit. The blue light absorption materials may be selected from perylene, pyrene, coumarin, ethynylanthracene, or other suitable yellow colorants.

The color conversion layer may be prepared by gap coating, drop coating, spray coating, roll coating, ink-jetting, spin coating, or other suitable coating techniques. A pixilation process may be employed to fabricate the color conversion array. The pixilation process may be a photolithography process, wherein ultraviolet (UV) light rays are irradiated to selectively expose the red color conversion layer and the green color conversion layer in a sequential manner. The exposed layer is then developed to form a color conversion pattern. The developing process is performed using one of a dipping method, a bubble method and a shower spray method. After developing, the color conversion layer may be hardened at a high temperature condition of about 200-230° C. After the pixilation process, an acrylic resin or a polyamide resin may be utilized to deposit a planarization layer on the entire color conversion array surface, thereby forming a transparent overcoat layer.

In one embodiment, in addition to the color conversion array described above, the light emitting apparatus of the present invention further comprises a backlight unit that emits blue light. Preferably, the backlight unit is an active matrix light emitting diode. More preferably, the backlight unit is an active matrix OLED.

In another embodiment, the light emitting apparatus of the present invention may further comprise a liquid crystal component that can function as the light valve. In this case, the backlight unit may be a blue lamp. Preferably, the backlight unit is a blue LED lamp. In one embodiment, the liquid crystal component may be sandwiched between the backlight unit and the color conversion array. In another embodiment, the liquid crystal component may be placed on top of the color conversion array which overlays the backlight unit.

The light emitting apparatus of the present invention may be used in various devices including, for example, televisions, mobile phones, tablets, and automotive electronics. The present invention also relates to an electronic device comprising the light emitting apparatus. The electronic device may be selected from LCD displays, OLED displays, or LED displays.

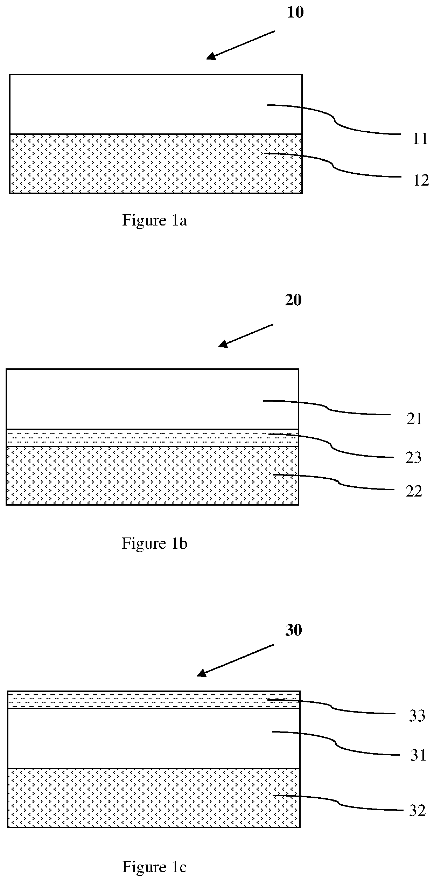

With reference to Figure 1a, there is shown a schematic perspective view of one embodiment of a light emitting apparatus **10** disclosed herein comprising color conversion array **11,** and backlight unit **12.**

With reference to Figure 1b, there is shown a schematic perspective view of one embodiment of a light emitting apparatus **20** disclosed herein comprising color conversion array **21,** backlight unit **22,** and liquid crystal component **23** sandwiched therebetween.

With reference to Figure 1c, there is shown a schematic perspective view of one embodiment of a light emitting apparatus **30** disclosed herein comprising color conversion array **31,** backlight unit **32,** and liquid crystal component **33,** so that color conversion array **31** resides between backlight unit **32** and liquid crystal component **33.**

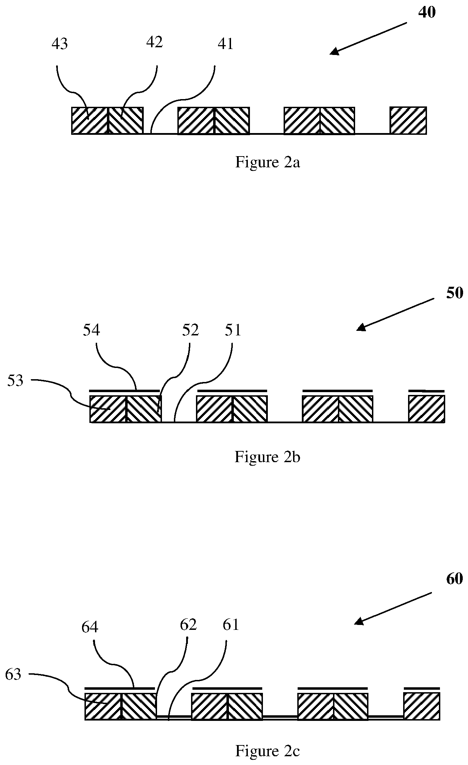

With reference to Figure 2a, there is shown a cross section of one embodiment of color conversion array **40** in a light emitting apparatus of the present invention. Color conversion array **40** comprises, blue pixel area **41,** green color conversion layer **42** comprising the first nanoparticles, and red color conversion layer **43** comprising the second nanoparticles.

With reference to Figure 2b, there is shown a cross section of one embodiment of color conversion array **50** in a light emitting apparatus of the present invention. Color conversion array **50** comprises, blue pixel area **51,** green color conversion layer **52** comprising the first nanoparticles, and red color conversion layer **53** comprising the second nanoparticles. Color conversion array **50** further comprises blue light blocking layer **54** on top of green color conversion layer **52** and red color conversion layer **53.**

With reference to Figure 2c, there is shown a schematic perspective view of one embodiment of color conversion array **60** in a light emitting apparatus of the present invention. Color conversion array **60** comprises, blue pixel area **61,** green color conversion layer **62** comprising the first nanoparticles, and red color conversion layer **63** comprising the second nanoparticles. Color conversion array **60** further comprises light blocking layer **64** on top of blue pixel area **61,** green color conversion layer **62,** and red color conversion layer **63.**

### EXAMPLES

Some embodiments of the invention will now be described in the following Examples, wherein all parts and percentages are by weight unless otherwise specified.

The following materials are used in the examples:
All solvents and reagents were obtained from commercial vendors, and were used in the highest available purities or analytical grade unless otherwise specified.

Tetraethyl orthosilicate ("TEOS"), zirconium n-butoxide (80 weight percent (wt%) in butanol), tetrabutyl orthotitanate ("TBOT"), methyltrimethoxysilane ("MTMS"), methyltriethoxysilane ("MTES"), n-Propyltrimethoxysilane ("MPTS"), trimethoxysilane, 2-triethoxylsilane, allyl-phenol, POCl₃, phenol, and allyl bromide (CAS No. 106-95-6) are all available from Sigma Aldrich.

Anhydrous ethanol, 2-Propanol, ammonia (25-28 wt%), N,N-Dimethylformamide ("DMF"), 1,2-dichloroethane ("DCE"), dichloromethane ("DCM"), 2,3-dicyano-5,6-dichlorobenzoquinone ("DDQ"), N-methyl-pyrrolidone ("NMP"), petroleum ether, NH₄Cl, NaHCO₃, Na₂SO₄, K₂CO₃, tetrahydrofuran ("THF"), ethyl acetate ("EA"), and methanol are all available from Sinopharm Chemical Reagent Co. Ltd.

Propylene glycol monomethyl ether acetate ("PGMEA") is available from TCI Chemicals.

Karstedt's catalyst, available from J&K Scientific Ltd., is platinum divinyltetramethy-siloxane complex in xylene (3 wt%).

N,N'-Bis(2,6-diisopropylphenyl)-1,6,7,12-tetrachloroperylene-3,4:9,10-tetracarboxylic acid diimide (CAS No. 156028-26-1) is from Shanghai YuanYe Biotechnology Co. Ltd.

PLEXIGLAS 6N polymethyl methacrylate ("PMMA"), available from Evonik Degussa, is used as a binder.

Sample A, available from Showa Denko, is an acrylic binder (30% in PGMEA). 1-[9-Ethyl-6-(2-methylbenzoyl)-9H-carbazol-3-yl]-ethanone-1-(O-acetyloxime) ("OXE-02", CAS No. 478556-66-0) is available from BASF and used as a photo initiator.

### Synthesis of the first nanoparticles

### (1) Synthesis of functionalized organic light emitting compound 1

To a solution of 4-hydroxybenzaldehyde (4.0 grams (g), 32.7 mmol, 1.0 equivalent (equiv.)) in acetone (40 mL), K₂CO₃ (13.6 g, 3.0 equiv.) and allyl bromide (4.3 mL, 1.5 equiv.) were added. The reaction mixture was stirred at room temperature for 2 hours and further heated to reflux overnight. After cooling to room temperature, the solution was filtered, washed with acetone and concentrated in vacuo, which afford 4-(allyloxy)benzaldehyde.

A few drops of trifluoroacetic acid were added to a 200 mL dichloromethane solution of ethyl 2,4-dimethyl-1H-pyrrole-3-carboxylate (2.1 g, 2.0 equiv.) and aldehyde (1.0 g, 1.0 equiv.). The dark reaction mixture was stirred at room temperature until total disappearance of the aldehyde. The oxidizing agent (DDQ, 1.4 g), then 30 minutes later 13.0 mL Et₃N and finally 15.0 mL trifluoroborate etherate were successively added. The mixture was filtered through a pad of silica or used crude. The filtrate was concentrated and the residue was purified by chromatography on silica or alumina gel or by automatic chromatography to afford an allyl functionalized BODIPY (yield, 75%).

100 mg of the above synthesized allyl functionalized BODIPY (0.2 mmol) was dissolved into toluene. Under nitrogen, HSi(OEt)₃ (125 mg, 4.0 equiv.) was injected through a septum, followed by the addition of a drop of Karstedt's catalyst. The resulting mixture was stirred at 60°C overnight. The solution was evaporated under reduced pressure. The crude product of the functionalized organic light emitting compound 1 was obtained without further purification.

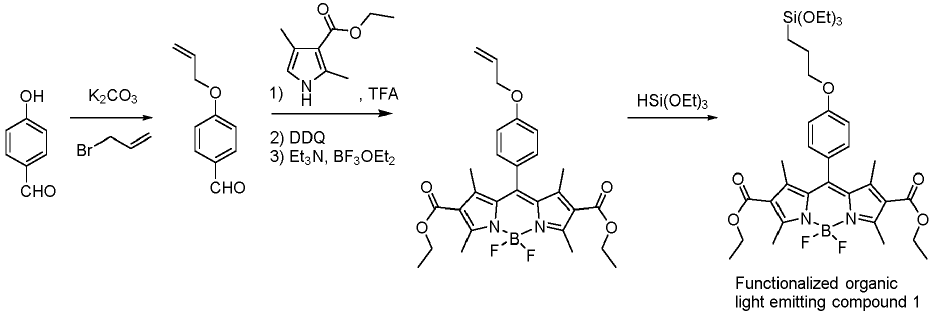

### (2) Synthesis of the first nanoparticles

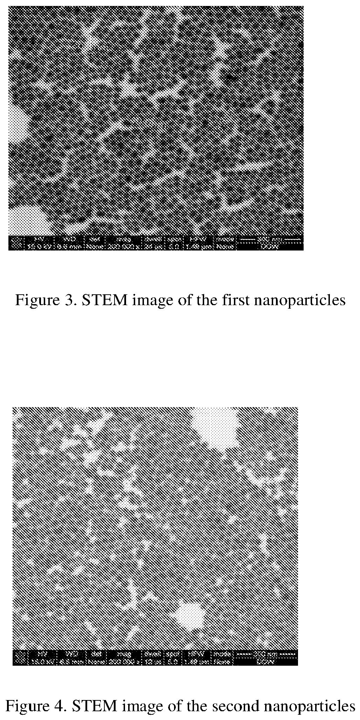

70 mL ethanol was added to 250 mL three-neck flask, followed by 5 mL ammonia. The mixture was slowly stirred while heated to 50°C. Calculated amount of the functionalized organic light emitting compound 1 dissolved in 30 mL ethanol together with 3 mL TEOS were added into the reaction flask. The resulting mixture was stirred for 3 hours at 50°C. 2 mL TEOS and 305 µL TBOT were dissolved into 18 mL isopropanol and then dropped into the reaction flask in 180 minutes by peristaltic pump, keep stirring at 50°C overnight. 2.7 mL methyl triethoxysilane was added into the reaction flask and kept stirring at 50°C for 4-5 hours. The obtained colloidal suspension was collected via centrifuge and washed with ethanol three times. The obtained nanoparticles (first nanoparticles) were evaluated by dynamic light scattering (DLS, Malvern Zetasizer Nano) for particle size distribution analysis, and scanning transmission electron microscopy (STEM, Nova™ NanoSEM 630) for particle morphology and size analysis. Results are given in Table 1 and Figure 3.

### Synthesis of the second nanoparticles

### (1) Synthesis of functionalized organic light emitting compound 2

N,N'-Bis(2,6-diisopropylphenyl)-1,6,7,12-tetrachloroperylene-3,4:9,10-tetracarboxylic acid diimide (1.50 g, 1.76 mmol) was treated with 2-allyl-phenol (1.42 g, 10.58 mmol) and K₂CO₃ (1.46 g, 10.58 mmol) in N-methyl-pyrrolidone (50 mL). The reaction mixture was heated at 80°C under N₂ for 16 hours, then allowed to cool to room temperature, and diluent hydrochloric acid (100 mL) was added. A precipitate was formed and filtered off, washed with water to neutral pH, and dried under vacuum. The crude product was then purified by column chromatography on silica gel with a dichloromethane/ petroleum ether (1:1) solvent mixture. The pure purple solid was obtained after drying (1.15 g, 53% yield).

0.5 g of the above obtained product was dissolved into 30 mL NMP, and then 4.0 equiv. excessive amount of phenol and K₂CO₃ were added. The mixture was stirred at 100 °C over 24 hours. Then, a diluent (HCl aqueous solution) was added. A precipitate was formed and was filtered off, washed with water, then hot water to neutral pH, and dried under vacuum. The crude product was then purified by column chromatography on silica gel with a dichloromethane/ petroleum ether (1:1) solvent mixture. The obtained allyl functionalized products were used for further hydrosilylation with triethoxylsilane.

60 mg of the as-prepared allyl functionalized products (0.05 mmol) was dissolved into 5 mL THF. Under N₂, HSi(OEt)₃ (0.1 mL, 10.0 equiv.) was injected through a septum, followed by the addition of a drop of Karstedt's catalyst (platinum divinyltetramethy-siloxane complex in xylene, 3wt%). The resulting mixture was stirred at 60°C overnight. The solution was evaporated under reduced pressure. The crude product of the functionalized organic light emitting compound 2 was obtained without further purification. Schematics of synthesis of the functionalized organic light emitting compound 2 are shown as follows,

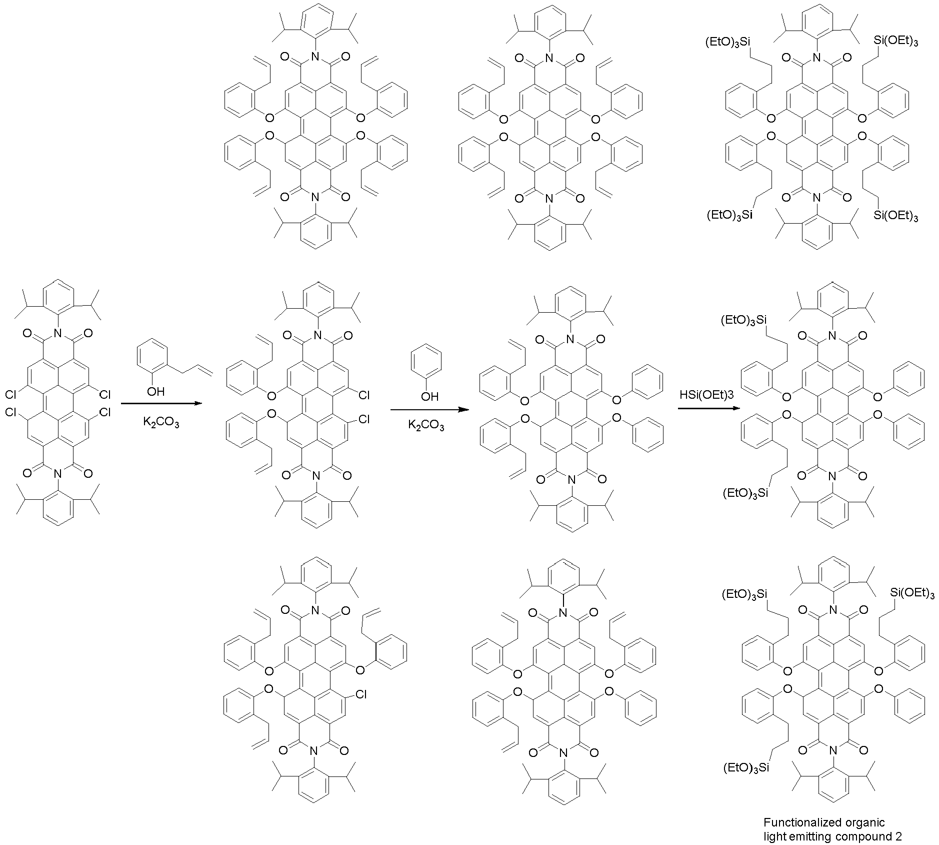

### (2) Synthesis of the second nanoparticles

70 mL ethanol was added to 250 mL three-neck flask, followed by 5 mL ammonia. The mixture was slowly stirred while heated to 50°C. Calculated amount of the functionalized organic light emitting compound 2 dissolved in 30 mL ethanol together with 3 mL TEOS were added into the reaction flask. The resulting mixture was stirred for 3 hours at 50°C. 2 mL TEOS and 305 µL TBOT were dissolved into 18 mL isopropanol and then dropped into the reaction flask in 180 minutes by peristaltic pump, keep stirring at 50 °C overnight. 2.7 mL methyl triethoxysilane was added into the reaction flask and kept stirring at 50°C for 4-5 hours. The obtained colloidal suspension was collected via centrifuge and washed with ethanol three times. The obtained nanoparticles (second nanoparticles) were characterized by STEM (Nova™ NanoSEM 630) for particle morphology and size analysis and the STEM image is given in Figure 4.

Table 1 shows typical DLS results of the first nanoparticles at different synthetic stage. The first nanoparticles have a unimodal distribution with core particle size of around 48 nm and shell layer thickness of around 8 nm. After surface modification, the final particle size is around 58 nm. Since the particle size obtained from DLS was hydrodynamic diameter, the particle size obtained from DLS was larger than that obtained from STEM.

**Table 1**

| Particle size at different synthetic stages via DLS | | |
|---|---|---|
| First nanoparticles | Particle Size (Z-average) / nm | Polydispersity index (PDI) |
| Core | 48 | 0.188 |
| Core-shell | 56 | 0.138 |
| Final (after surface modification) | 58 | 0.163 |

Figure 3 and 4 show STEM images of the first and second nanoparticles, respectively. As seen from the Figures, the nanoparticles had a fairly narrow size distribution, with particle sizes around 30-40 nm.

### Example 1

150 mg of the first nanoparticles obtained above were dissolved into 1g of propylene glycol monomethyl ether acetate (PGMEA) to form a clear solution. The solution was then homogeneously mixed with 3 g of PMMA solution (30wt% in PGMEA), coated onto a polyethylene terephthalate (PET) film, and then dried in an oven at 80°C for 2 hours to evaporate PGMEA solvent. No barrier film or any tricks that would improve the barrier properties of the obtained first nanoparticles-PMMA film was used. The thickness of the dried film was around 80-100 µm. Storage stability and photostability properties of the first nanoparticles-PMMA film were determined according to the test method below.

### Storage stability

The storage stability test was conducted via the following steps: 1) Cut each nanoparticles-PMMA film sample into 4 pieces and place them in a humidity chamber; 2) Set the chamber at 90% of relative humidity (RH) and 60°C; and 3) Every 100 hours, a sample piece was taken out for photoluminescent test. The peak intensity of photoluminescence spectrum of the sample was tracked over time with spectrofluorometer (HORIBA FluoroMax-4).

### Photostability

A blue backlight unit of light intensity of 1450-1500 Cd/m² was used as the light source. The nanoparticles-PMMA film was placed in front of the blue backlight unit for continuous irradiation in open air. The peak intensity of photoluminescence spectrum was tracked over time with spectrofluorometer (HORIBA FluoroMax-4). Results of retention of initial intensity vs. irradiation time are given in Table 2.

### Example 2

The second nanoparticles-PMMA film was prepared according to the same procedure as described above for preparing the first nanoparticles-PMMA film of Example 1. Photostability of the second nanoparticles-PMMA film was evaluated according to the test method described above in Example 1.

Storage stability of the first nanoparticles-PMMA film (Example 1) was evaluated according to the test described above. It shows that 73% of the initial emission intensity of the first nanoparticles-PMMA film was maintained after 406 hour storage at 60°C and 90%RH.

Table 2 gives photostability properties of films of Examples 1 and 2. As shown in Table 2, the first nanoparticles-PMMA and the second nanoparticles-PMMA films showed good photostability with about 82% and 100% retention of initial light intensity after 273 hours and 352 hours irradiation by blue backlight, respectively.

**Table 2**

| | Photostability of nanoparticles-PMMA films under blue backlight irradiation | |
|---|---|---|
| Sample | Irradiation hours | % of initial light intensity |
| Example 1 | 273 | 82 |
| Example 2 | 352 | 100 |

### Example 3

150 mg of the first nanoparticles obtained above was dissolved into 1.2 g of PGMEA to form a clear solution. The solution was then homogeneously mixed with a photoresist binder developed for traditional color filters (Sample A acrylic binder (30wt% in PGMEA), available from Showa Denko) and 9 mg of a photo initiator OXE-02. After thorough mixing, the mixture was coated onto a glass substrate via spin coating and then pre-baked in an oven at 100°C for 2 minutes. The resulted film was irradiated under 365 nm UV with an intensity of 50 mJ/cm², followed by baking at 230°C for 30 minutes twice. The photoluminescence spectrum of the sample was recorded before and after each step with spectrofluorometer (HORIBA FluoroMax-4). Stability of the first nanoparticles under UV curing and hard-baking conditions is given in Table 3.

Table 3 shows the stability performance of first nanoparticles in the acrylic binder towards the UV curing and hard-baking conditions commonly used for forming a conventional color filter array. As shown in Table 3, the first nanoparticles in the acrylic binder were quite stable toward the UV curing conditions. After two baking cycles at 230°C, 59% of its initial emission peak intensity was maintained.

In summary, the as prepared nanoparticles have good color performance, and good photostability and storage stability at 60°C and 90%RH. More importantly, they can sustain the UV curing and hard-baking conditions commonly used for preparing color filters. Therefore, the nanoparticles are suitable for use in color conversion layers of color filters.

**Table3**

| | Stability of the first nanoparticles under UV curing and hard-baking conditions | | | |
|---|---|---|---|---|
| Sample | Process | Peak, nm | FWHM, nm | % of initial light intensity |
| Example 3 | After pre-baking at 100°C | 509 | 30 | 100 |
| | After 365 nm UV irradiation | 509 | 29 | 100 |
| | After the first time baking at 230°C | 508 | 34 | 63 |
| | After the second time baking at 230°C | 508 | 34 | 59 |

## Claims

1. A light emitting apparatus comprising:
a backlight unit that emits blue light, and
a color conversion array receiving the blue light from the backlight unit;
wherein the color conversion array comprises a green color conversion layer and a red color conversion layer,
wherein at least one of the green color conversion layer and the red color conversion layer comprises first or second nanoparticles that emit green or red light respectively, and said first or second nanoparticles are encapsulated organic light emitting compounds where the organic light emitting compound has an absorption of at least 1000 M⁻¹ cm⁻¹ in a spectral region of 430-500 nm and exhibits a full width half maximum of the emission band of less than 100 nm;
wherein the color conversion array comprises a green color conversion layer comprising the first nanoparticles, and a red color conversion layer comprising the second nanoparticles;
wherein the first nanoparticles comprise encapsulated organic emitting compounds and the organic light emitting compounds have the structure of formula (I): 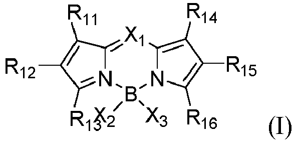
wherein R₁₁ through R₁₆ are each independently selected from H, a halogen, -CN,-CF₃, -NO₂, a substituted or unsubstituted C₁-C₂₄ alkyl, a substituted or unsubstituted C₂-C₂₄ alkenyl, a substituted or unsubstituted C₂-C₂₄ alkynyl, a substituted or unsubstituted C₁-C₂₄ alkoxy, a substituted or unsubstituted C₃-C₂₀ cyclic or heterocyclic group, -SO₃H, sulfonate,-SO₂O-, a thio ether, an ether, a urea, -CO₂H, an ester, an amide, an amine, a C₆-C₂₀ substituted or unsubstituted aromatic group, or a C₅-C₂₀ substituted or unsubstituted heteroaromatic group; R₁₁ and R₁₂ may join together to form a 5-, 6-, 7-membered ring together with the atoms they are bonded; R₁₂ and R₁₃ may join together to form a 5-, 6-, 7-membered ring together with the atoms they are bonded; R₁₄ and R₁₅ may join together to form a 5-, 6-, 7-membered ring together with the atoms they are bonded; and R₁₅ and R₁₆ may join together to form a 5-, 6-, 7-membered ring together with the atoms they are bonded;
wherein X₁ is N or CR₁₇, wherein R₁₇ is selected from H, a halogen, -CN, -CF₃, a substituted or unsubstituted C₁-C₂₄ alkyl, a substituted or unsubstituted C₂-C₂₄ alkenyl, a substituted or unsubstituted C₂-C₂₄ alkynyl, a substituted or unsubstituted C₁-C₂₄ alkoxy, a substituted or unsubstituted C₃-C₂₀ cyclic or heterocyclic group, a substituted or unsubstituted C₆-C₂₀ aromatic group, a substituted or unsubstituted C₅-C₂₀ heteroaromatic group, an ether, an ester, a carboxylic acid, -OH, an amide, an amine, or a sulfide; and
wherein X₂ and X₃ are each independently selected from a halogen, a substituted or unsubstituted C₁-C₂₄ alkyl, a substituted or unsubstituted C₂-C₂₄ alkenyl, a substituted or unsubstituted C₂-C₂₄ alkyne, a substituted or unsubstituted C₃-C₂₀ cyclic or heterocyclic group, a C₆-C₂₀ substituted or unsubstituted aromatic group, a substituted or unsubstituted C₅-C₂₀ heteroaromatic group, or a substituted or unsubstituted C₁-C₂₄ alkoxy; and X₂ and X₃ may join together to form a single substituent group; and
wherein the second nanoparticles comprise encapsulated organic light emitting compounds and the organic light emitting compounds are selected from perylenediimide, boron-dipyrromethene, diketopyrrolopyrrol, 4-dicyanomethylene-2-*t*-*butyl*-6-1,1,7,7-tetramethyljulolidyl-9-enyl-4*H*-pyran, coumarin, rhodamine, fluorescein, and cyanine.

2. The light emitting apparatus of claim 1, wherein the first and second nanoparticles each comprise a silica containing core covalently bonded with a luminophore derived from the organic light emitting compound and a shell at least partially encapsulating the core.

3. The light emitting apparatus of claim 2, wherein the first and second nanoparticles each independently comprise:
a core comprising a reaction product of a functionalized organic light emitting compound and a first precursor, wherein the functionalized organic light emitting compound has the structure of D-L-SiX₃, wherein D is a luminophore, L is a direct bond or an organic group, and X is a hydrolyzable substituent; and the first precursor is selected from (a) a first organic silane compound having the structure of SiX¹₄, (b) a first organic metal compound having the structure of MX¹₃ or MX¹₄, or mixtures thereof; wherein each X¹ is independently a hydrolyzable substituent, and M is selected from Al, Zr, Ti, or combinations thereof; and
a shell comprising a reaction product of a second precursor, wherein the second precursor is selected from (a) a second organic silane compound having the structure of SiX²₄, (b) a second organic metal compound having the structure of MX²₃ or MX²₄, or mixtures thereof; wherein each X² is independently a hydrolyzable substituent, and M is selected from Al, Zr, Ti, or combinations thereof.

4. The light emitting apparatus of claim 3, wherein the second precursor is a mixture of the second organic silane compound and the second organic metal compound, wherein the molar ratio of the second organic silane compound to the second organic metal compound is from 1:1 to 100:1.

5. The light emitting apparatus of claim 2, wherein the first and second nanoparticles each independently comprise:
a core comprising a reaction product of a functionalized organic light emitting compound and a first precursor, wherein the functionalized organic light emitting compound has the structure of D-L-SiX₃, wherein D is a luminophore, L is a direct bond or an organic group, and X is a hydrolyzable substituent; and the first precursor is selected from a first organic silane compound having the structure of SiX¹₄; wherein each X¹ is independently a hydrolyzable substituent; and
a shell comprising a reaction product of a second precursor, wherein the second precursor is selected from (a) a second organic silane compound having the structure of SiX²₄; wherein each X² is independently a hydrolyzable substituent.

6. The light emitting apparatus of claim 1, wherein the first and second nanoparticles are each independently prepared by a process comprising:
(i) providing a functionalized organic light emitting compound, wherein the functionalized organic light emitting compound has the structure of D-L-SiX₃, wherein D is a luminophore, L is a direct bond or an organic group, and X is a hydrolyzable substituent;
(ii) adding a first precursor, wherein the first precursor is selected from a first organic silane compound having the structure of SiX¹₄, a first organic metal compound having the structure of MX¹₃ or MX¹₄, or mixtures thereof; wherein each X¹ is independently a hydrolyzable substituent, and M is selected from Al, Zr, Ti, or combinations thereof; and
(iii) adding a second precursor, wherein the second precursor comprises (a) a second organic silane compound having the structure of SiX²₄, (b) a second organic metal compound having the structure of MX²₃ or MX²₄, or mixtures thereof; wherein each X² is independently a hydrolyzable substituent, and M is selected from Al, Zr, Ti, or combinations thereof; thus to obtain the nanoparticles.

7. The light emitting apparatus of claim 6, wherein the process further comprises:
(iv) adding a surface modifier having the structure of R¹ₘSi(R²)₄₋ₘ, wherein R¹ is selected from a C₁-C₂₀ substituted or unsubstituted alkyl, a C₂-C₂₀ substituted or unsubstituted alkenyl, or a C₆-C₂₄ substituted or unsubstituted aryl group; R² is a hydrolysable group; and m is an integer of 1 to 3.

8. The light emitting apparatus of claim 1, wherein the organic light emitting compounds for preparing the first nanoparticles have the structure of formula (II): 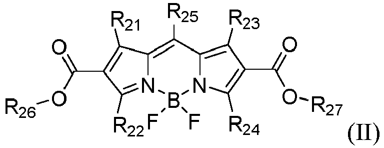 wherein R₂₁ through R₂₅ are each independently selected from H, a halogen, -CN,-CF₃, -NO₂, a substituted or unsubstituted C₁-C₂₄ alkyl, a substituted or unsubstituted C₂-C₂₄ alkenyl, a substituted or unsubstituted C₂-C₂₄ alkynyl, a substituted or unsubstituted C₁-C₂₄ alkoxy, a substituted or unsubstituted C₃-C₂₀ cyclic or heterocyclic group, -SO₃H, sulfonate,-SO₂O-, a thio ether, an ether, a urea, -CO₂H, an ester, an amide, an amine, a substituted or unsubstituted C₆-C₂₀ aromatic group, or a substituted or unsubstituted C₅-C₂₀ heteroaromatic group; and R₂₆ and R₂₇ are each independently selected from a substituted or unsubstituted C₁-C₂₀ alkyl, a substituted or unsubstituted C₂-C₂₀ alkenyl, a substituted or unsubstituted C₂-C₂₄ alkynyl, a substituted or unsubstituted C₁-C₂ alkoxy, a substituted or unsubstituted C₆-C₂₄ aryl group; a substituted or unsubstituted C₃-C₂₀ cyclic or heterocyclic group, or a substituted or unsubstituted C₅-C₂₀ heteroaromatic group.

9. The light emitting apparatus of claim 1 or 2, wherein the first and second nanoparticles each independently have a particle size in the range of from 10 to 2,000 nm.

10. The light emitting apparatus of claim 1, wherein the wavelength of the light from the backlight unit is from 430 to 500 nm.

11. The light emitting apparatus of claim 1, wherein the color conversion array further comprises one or more blue light blocking layers comprising one or more than one blue light absorption materials, placed on top of the red color conversion layer and/or the green color conversion layer away from the backlight unit.

12. The light emitting apparatus of claim 1, wherein the red color conversion layer further comprises organic red light emitting compounds, inorganic phosphors, quantum dots, or mixtures thereof.

13. The light emitting apparatus of claim 1, wherein the green color conversion layer further comprises organic green light emitting compounds, inorganic phosphors, quantum dots, or mixtures thereof.

14. An electronic device comprising a light emitting apparatus of any one of claims 1-13.

15. The electronic device of claim 14, wherein the electronic device is selected from LCD displays, LED displays, or OLED displays.

## Patentansprüche

1. Lichtemittierende Vorrichtung, umfassend:
eine Hintergrundbeleuchtungseinheit, die blaues Licht emittiert, und
eine Farbumwandlungsanordnung, die das blaue Licht von der Hintergrundbeleuchtungseinheit empfängt;
wobei die Farbumwandlungsanordnung eine grüne Farbumwandlungsschicht und eine rote Farbumwandlungsschicht umfasst,
wobei mindestens eine der grünen Farbumwandlungsschicht und der roten Farbumwandlungsschicht erste oder zweite Nanopartikel umfasst, die grünes bzw. rotes Licht emittieren, und die ersten oder zweiten Nanopartikel eingekapselte organische lichtemittierende Verbindungen sind, wobei die organische lichtemittierende Verbindung eine Absorption von mindestens 1000 M⁻¹ cm⁻¹ in einem Spektralbereich von 430-500 nm aufweist und eine Halbwertsbreite der Emissionsbande von weniger als 100 nm aufweist;
wobei die Farbumwandlungsanordnung eine grüne Farbumwandlungsschicht umfasst, die die ersten Nanopartikel umfasst, und eine rote Farbumwandlungsschicht, die die zweiten Nanopartikel umfasst;
wobei die ersten Nanopartikel eingekapselte organische emittierende Verbindungen umfassen und die organischen lichtemittierenden Verbindungen die Struktur der Formel (I) aufweisen: 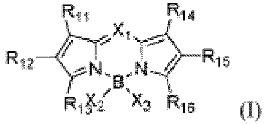
wobei R₁₁ bis R₁₆ jeweils unabhängig aus H, einem Halogen, -CN, -CF₃, -NO₂, einem substituierten oder nicht substituierten C₁-C₂₄-Alkyl, einem substituierten oder nicht substituierten C₂-C₂₄-Alkenyl, einem substituierten oder nicht substituierten C₂-C₂₄-Alkynyl, einem substituierten oder nicht substituierten C₁-C₂₄-Alkoxy, einer substituierten oder nicht substituierten cyclischen oder heterocyclischen C₃-C₂₀-Gruppe, -SO₃H, Sulfonat, -SO₂O-, einem Thioether, einem Ether, einem Harnstoff, -CO₂H, einem Ester, einem Amid, einem Amin, einer substituierten oder nicht substituierten aromatischen C₆-C₂₀-Gruppe oder einer substituierten oder nicht substituierten heteroaromatischen C₅-C₂₀-Gruppe ausgewählt sind; R₁₁ und R₁₂ sich verbinden können, um einen 5-, 6-, 7-gliedrigen Ring zusammen mit den Atomen, an die sie gebunden sind, zu bilden; R₁₂ und R₁₃ sich verbinden können, um einen 5-, 6-, 7-gliedrigen Ring zusammen mit den Atomen, an die sie gebunden sind, zu bilden; R₁₄ und R₁₅ sich verbinden können, um einen 5-, 6-, 7-gliedrigen Ring zusammen mit den Atomen, an die sie gebunden sind, zu bilden; und R₁₅ und R₁₆ sich verbinden können, um einen 5-, 6-, 7-gliedrigen Ring zusammen mit den Atomen, an die sie gebunden sind, zu bilden;
wobei X₁ N oder CR₁₇ ist, wobei R₁₇ aus H, einem Halogen, -CN, -CF₃, einem substituierten oder nicht substituierten C₁-C₂₄-Alkyl, einem substituierten oder nicht substituierten C₂-C₂₄-Alkenyl, einem substituierten oder nicht substituierten C₂-C₂₄-Alkynyl, einem substituierten oder nicht substituierten C₁-C₂₄-Alkoxy, einer substituierten oder nicht substituierten cyclischen oder heterocyclischen C₃-C₂₀-Gruppe, einer substituierten oder nicht substituierten aromatischen C₆-C₂₀-Gruppe, einer substituierten oder nicht substituierten heteroaromatischen C₅-C₂₀-Gruppe, einem Ether, einem Ester, einer Carbonsäure, -OH, einem Amid, einem Amin oder einem Sulfid ausgewählt ist; und
wobei X₂ und X₃ jeweils unabhängig aus einem Halogen, einem substituierten oder nicht substituierten C₁-C₂₄-Alkyl, einem substituierten oder nicht substituierten C₂-C₂₄-Alkenyl, einem substituierten oder nicht substituierten C₂-C₂₄-Alkynyl, einer substituierten oder nicht substituierten cyclischen oder heterocyclischen C₃-C₂₀-Gruppe, einer substituierten oder nicht substituierten aromatischen C₆-C₂₀-Gruppe, einer substituierten oder nicht substituierten heteroaromatischen C₅-C₂₀-Gruppe oder einem substituierten oder nicht substituierten C₁-C₂₄-Alkoxy ausgewählt sind; und X₂ und X₃ sich verbinden können, um eine Gruppe mit einem einzelnen Substituenten zu bilden; und
wobei die zweiten Nanopartikel verkapselte organische lichtemittierende Verbindungen umfassen und die organischen lichtemittierenden Verbindungen aus Perylenediimid, Bor-Dipyrromethen, Diketopyrrolopyrrol, 4-Dicyanomethylen-2-*t*-*butyl-*6-1,1,7,7-tetramethyljulolidyl-9-enyl-4*H*-pyran, Cumarin, Rhodamin, Fluorescein und Cyanin ausgewählt sind.

2. Lichtemittierende Vorrichtung nach Anspruch 1, wobei die ersten und zweiten Nanopartikel jeweils einen Siliciumdioxid enthaltenden Kern, der kovalent mit einem von der organischen lichtemittierenden Verbindung abgeleiteten Luminophor verbunden ist, und eine Hülle, die den Kern mindestens teilweise einkapselt, umfassen.

3. Lichtemittierende Vorrichtung nach Anspruch 2, wobei die ersten und zweiten Nanopartikel jeweils unabhängig Folgendes umfassen:
einen Kern, umfassend ein Reaktionsprodukt aus einer funktionalisierten organischen lichtemittierenden Verbindung und einem ersten Vorläufer, wobei die funktionalisierte organische lichtemittierende Verbindung die Struktur D-L-S₁X₃ hat, wobei D ein Luminophor ist, L eine direkte Bindung oder eine organische Gruppe ist und X ein hydrolysierbarer Substituent ist; und der erste Vorläufer aus (a) einer ersten organischen Silanverbindung mit der Struktur SiX¹₄, (b) einer ersten organischen Metallverbindung mit der Struktur MX¹₃ oder MX¹₄ oder Mischungen davon ausgewählt ist; wobei jedes X¹ unabhängig ein hydrolysierbarer Substituent ist und M aus Al, Zr, Ti oder Kombinationen davon ausgewählt ist; und
eine Hülle, umfassend ein Reaktionsprodukt eines zweiten Vorläufers, wobei der zweite Vorläufer aus (a) einer zweiten organischen Silanverbindung mit der Struktur SiX²₄, (b) einer zweiten organischen Metallverbindung mit der Struktur MX²₃ oder MX²₄ oder Mischungen davon ausgewählt ist; wobei jedes X² unabhängig ein hydrolysierbarer Substituent ist und M aus Al, Zr, Ti, oder Kombinationen davon ausgewählt ist.

4. Lichtemittierende Vorrichtung nach Anspruch 3, wobei der zweite Vorläufer eine Mischung aus der zweiten organischen Silanverbindung und der zweiten organischen Metallverbindung ist, wobei das molare Verhältnis der zweiten organischen Silanverbindung zu der zweiten organischen Metallverbindung 1:1 bis 100:1 beträgt.

5. Lichtemittierende Vorrichtung nach Anspruch 2, wobei die ersten und zweiten Nanopartikel jeweils unabhängig umfassen:
einen Kern, umfassend ein Reaktionsprodukt aus einer funktionalisierten organischen lichtemittierenden Verbindung und einem ersten Vorläufer, wobei die funktionalisierte organische lichtemittierende Verbindung die Struktur D-L-S₁X₃ hat, wobei D ein Luminophor ist, L eine direkte Bindung oder eine organische Gruppe ist und X ein hydrolysierbarer Substituent ist; und der erste Vorläufer aus einer ersten organischen Silanverbindung mit der Struktur SiX¹₄ ausgewählt ist, wobei jedes X¹ unabhängig ein hydrolysierbarer Substituent ist; und
eine Hülle, umfassend ein Reaktionsprodukt eines zweiten Vorläufers, wobei der zweite Vorläufer aus (a) einer zweiten organischen Silanverbindung mit der Struktur SiX²₄ ausgewählt ist; wobei jedes X² unabhängig ein hydrolysierbarer Substituent ist.

6. Lichtemittierende Vorrichtung nach Anspruch 1, wobei die ersten und zweiten Nanopartikel jeweils unabhängig durch einen Prozess hergestellt werden, umfassend:
(i) Bereitstellen einer funktionalisierten organischen lichtemittierenden Verbindung, wobei die funktionalisierte organische lichtemittierende Verbindung die Struktur D-L-S₁X₃ aufweist, wobei D ein Luminophor ist, L eine direkte Bindung oder eine organische Gruppe ist und X ein hydrolysierbarer Substituent ist;
(ii) Hinzufügen eines ersten Vorläufers, wobei der erste Vorläufer aus einer ersten organischen Silanverbindung mit der Struktur SiX¹₄, einer ersten organischen Metallverbindung mit der Struktur MX¹₃ oder MX¹₄ oder Mischungen davon ausgewählt ist, wobei jedes X¹ unabhängig ein hydrolysierbarer Substituent ist und M aus Al, Zr, Ti oder Kombinationen davon ausgewählt ist; und
(iii) Hinzufügen eines zweiten Vorläufers, wobei der zweite Vorläufer (a) eine zweite organische Silanverbindung mit der Struktur SiX²₄, (b) eine zweite organische Metallverbindung mit der Struktur MX²₃ oder MX²₄ oder Mischungen davon umfasst; wobei jedes X² unabhängig ein hydrolysierbarer Substituent ist und M aus Al, Zr, Ti, oder Kombinationen davon ausgewählt ist; um so die Nanopartikel zu erhalten.

7. Lichtemittierende Vorrichtung nach Anspruch 6, wobei der Prozess ferner umfasst:
(iv) Hinzufügen eines Oberflächenmodifikators mit der Struktur R¹ₘSi(R²)₄₋ₘ, wobei R¹ aus einem substituierten oder nicht substituierten C₁-C₂₀-Alkyl, einem substituierten oder nicht substituierten C₂-C₂₀-Alkenyl oder einer substituierten oder nicht substituierten C₆-C₂₄-Arylgruppe ausgewählt ist; R² eine hydrolysierbare Gruppe ist; und m eine ganze Zahl von 1 bis 3 ist.

8. Lichtemittierende Vorrichtung nach Anspruch 1, wobei die organischen lichtemittierenden Verbindungen zum Herstellen der ersten Nanopartikel die Struktur der Formel (II) aufweisen: 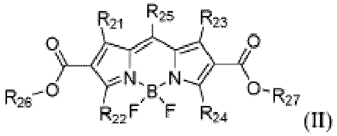 wobei R₂₁ bis R₂₅ jeweils unabhängig aus H, einem Halogen, -CN, -CF₃, -NO₂, einem substituierten oder nicht substituierten C₁-C₂₄-Alkyl, einem substituierten oder nicht substituierten C₂-C₂₄-Alkenyl, einem substituierten oder nicht substituierten C₂-C₂₄-Alkynyl, einem substituierten oder nicht substituierten C₁-C₂₄-Alkoxy, einer substituierten oder nicht substituierten cyclischen oder heterocyclischen C₃-C₂₀-Gruppe, -SO₃H, Sulfonat, -SO₂O-, einem Thioether, einem Ether, einem Harnstoff, -CO₂H, einem Ester, einem Amid, einem Amin, einer substituierten oder nicht substituierten aromatischen C₆-C₂₀-Gruppe oder einer substituierten oder nicht substituierten heteroaromatischen C₅-C₂₀-Gruppe ausgewählt sind; und R₂₆ und R₂₇ jeweils unabhängig aus einem substituierten oder nicht substituierten C₁-C₂₀-Alkyl, einem substituierten oder nicht substituierten C₂-C₂₀-Alkenyl, einem substituierten oder nicht substituierten C₂-C₂₄-Alkynyl, einem substituierten oder nicht substituierten C₁-C₂-Alkoxy, einer substituierten oder nicht substituierten C₆-C₂₄-Arylgruppe; einer substituierten oder nicht substituierten cyclischen oder heterocyclischen C₃-C₂₀-Gruppe oder einer substituierten oder nicht substituierten heteroaromatischen C₅-C₂₀-Gruppe ausgewählt sind.

9. Lichtemittierende Vorrichtung nach Anspruch 1 oder 2, wobei die ersten und zweiten Nanopartikel jeweils unabhängig eine Partikelgröße im Bereich von 10 bis 2.000 nm aufweisen.

10. Lichtemittierende Vorrichtung nach Anspruch 1, wobei die Wellenlänge des Lichts von der Hintergrundbeleuchtungseinheit 430 bis 500 nm beträgt.

11. Lichtemittierende Vorrichtung nach Anspruch 1, wobei die Farbumwandlungsanordnung ferner eine oder mehrere blaues Licht blockierende Schichten umfasst, die ein oder mehr als ein blaues Licht absorbierendes Material umfassen, die auf der roten Farbumwandlungsschicht und/oder der grünen Farbumwandlungsschicht entfernt von der Hintergrundbeleuchtungseinheit platziert sind.

12. Lichtemittierende Vorrichtung nach Anspruch 1, wobei die rote Farbumwandlungsschicht ferner organische rotes Licht emittierende Verbindungen, anorganische Phosphore, Quantenpunkte oder Mischungen davon umfasst.

13. Lichtemittierende Vorrichtung nach Anspruch 1, wobei die grüne Farbumwandlungsschicht ferner organische grünes Licht emittierende Verbindungen, anorganische Phosphore, Quantenpunkte oder Mischungen davon umfasst.

14. Elektronisches Bauelement, umfassend eine lichtemittierende Vorrichtung nach einem der Ansprüche 1-13.

15. Elektronisches Bauelement nach Anspruch 14, wobei das elektronische Bauelement aus LCD-Anzeigen, LED-Anzeigen oder OLED-Anzeigen ausgewählt ist.

## Revendications

1. Appareil à émission de lumière comprenant :
une unité de rétroéclairage qui émet une lumière bleue ; et
un réseau de conversion de couleur qui reçoit la lumière bleue en provenance de l'unité de rétroéclairage ;
dans lequel le réseau de conversion de couleur comprend une couche de conversion de couleur verte et une couche de conversion de couleur rouge ;
dans lequel au moins une parmi la couche de conversion de couleur verte et la couche de conversion de couleur rouge comprend des premières ou secondes nanoparticules qui émettent respectivement de la lumière verte ou rouge, et lesdites premières ou secondes nanoparticules sont des composés à émission de lumière organiques encapsulés où le composé à émission de lumière organique présente une absorption d'au moins 1 000 M⁻¹ cm⁻¹ dans une région spectrale de 430 à 500 nm et présente une largeur à mi-hauteur de la bande d'émission inférieure à 100 nm ;
dans lequel le réseau de conversion de couleur comprend une couche de conversion de couleur verte qui comprend les premières nanoparticules et une couche de conversion de couleur rouge qui comprend les secondes nanoparticules ;
dans lequel les premières nanoparticules comprennent des composés à émission de lumière organiques encapsulés et les composés à émission de lumière organiques présentent la structure de la formule (I) : 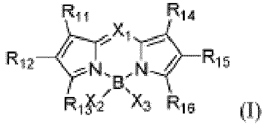
dans laquelle R₁₁ à R₁₆ sont, chacun de manière indépendante, sélectionnés parmi H, un halogène, -CN, -CF₃, -NO₂, un C₁-C₂₄ alkyle substitué ou non substitué, un C₂-C₂₄ alkényle substitué ou non substitué, un C₂-C₂₄ alkynyle substitué ou non substitué, un C₁-C₂₄ alcoxy substitué ou non substitué, un groupe C₃-C₂₀ cyclique ou hétérocyclique substitué ou non substitué, -SO₃H, sulfonate, -SO₂O-, un thioéther, un éther, une urée,-CO₂H, un ester, une amide, une amine, un groupe C₆-C₂₀ aromatique substitué ou non substitué ou un groupe C₅-C₂₀ hétéroaromatique substitué ou non substitué ; R₁₁ et R₁₂ peuvent être joints ensemble pour former un cycle à 5, 6, 7 éléments en association avec les atomes auxquels ils sont liés ; R₁₂ et R₁₃ peuvent être joints ensemble pour former un cycle à 5, 6, 7 éléments en association avec les atomes auxquels ils sont liés ; R₁₄ et R₁₅ peuvent être joints ensemble pour former un cycle à 5, 6, 7 éléments en association avec les atomes auxquels ils sont liés ; et R₁₅ et R₁₆ peuvent être joints ensemble pour former un cycle à 5, 6, 7 éléments en association avec les atomes auquels ils sont liés ;
dans laquelle X₁ est N ou CR₁₇, dans laquelle R₁₇ est sélectionné parmi H, un halogène, -CN, -CF₃, un C₁-C₂₄ alkyle substitué ou non substitué, un C₂-C₂₄ alkényle substitué ou non substitué, un C₂-C₂₄ alkynyle substitué ou non substitué, un C₁-C₂₄ alcoxy substitué ou non substitué, un groupe C₃-C₂₀ cyclique ou hétérocyclique substitué ou non substitué, un groupe C₆-C₂₀ aromatique substitué ou non substitué, un groupe C₅-C₂₀ hétéroaromatique substitué ou non substitué, un éther, un ester, un acide carboxylique, -OH, une amide, une amine, ou un sulfure ; et
dans laquelle X₂ et X₃ sont, chacun de manière indépendante, sélectionnés parmi un halogène, un C₁-C₂₄ alkyle substitué ou non substitué, un C₂-C₂₄ alkényle substitué ou non substitué, un C₂-C₂₄ alkynyle substitué ou non substitué, un groupe C₃-C₂₀ cyclique ou hétérocyclique substitué ou non substitué, un groupe C₆-C₂₀ aromatique substitué ou non substitué, un groupe C₅-C₂₀ hétéroaromatique substitué ou non substitué, ou un C₁-C₂₄ alcoxy substitué ou non substitué ; et X₂ et X₃ peuvent être joints ensemble pour former un unique groupe de substituant ; et
dans lequel les secondes nanoparticules comprennent des composés à émission de lumière organiques encapsulés et les composés à émission de lumière organiques sont sélectionnés parmi perylènediimide, bore-dipyrrométhane, dicétopyrrolopyrrol, 4-dicyanométhylène-2-*t*-*butyl*-6-1,1,7,7-tétraméthyljulolidyl-9-ényl-4*H*-pyrane, coumarine, rhodamine, fluorescine et cyanine.

2. Appareil à émission de lumière selon la revendication 1, dans lequel les premières et secondes nanoparticules comprennent chacune une âme contenant de la silice qui est liée de façon covalente avec un luminophore qui est dérivé à partir du composé à émission de lumière organique et une enveloppe qui encapsule au moins partiellement l'âme.

3. Appareil à émission de lumière selon la revendication 2, dans lequel les premières et secondes nanoparticules comprennent chacune de manière indépendante :
une âme qui comprend un produit de réaction d'un composé à émission de lumière organique fonctionnalisé et d'un premier précurseur, dans lequel le composé à émission de lumière organique fonctionnalisé présente la structure de D-L-SiX₃, dans laquelle D est un luminophore, L est une liaison directe ou un groupe organique et X est un substituant hydrolysable ; et le premier précurseur est sélectionné parmi (a) un premier composé de silane organique qui présente la structure de SiX¹₄, (b) un premier composé organométallique qui présente la structure de MX¹₃ ou de MX¹₄, ou des mélanges de ceux-ci ; dans laquelle chaque X¹ est de manière indépendante un substituant hydrolysable, et M est sélectionné parmi Al, Zr, Ti ou des combinaisons de ceux-ci ; et
une enveloppe qui comprend un produit de réaction d'un second précurseur, dans lequel le second précurseur est sélectionné parmi (a) un second composé de silane organique qui présente la structure de SiX²₄, (b) un second composé organométallique ayant la structure de MX²₃ ou de MX²₄, ou des mélanges de ceux-ci ; dans laquelle chaque X² est de manière indépendante un substituant hydrolysable, et M est sélectionné parmi Al, Zr, Ti ou des combinaisons de ceux-ci.

4. Appareil à émission de lumière selon la revendication 3, dans lequel le second précurseur est un mélange du second composé de silane organique et du second composé organométallique, dans lequel le rapport molaire du second composé de silane organique sur le second composé organométallique va de 1:1 à 100:1.

5. Appareil à émission de lumière selon la revendication 2, dans lequel les premières et secondes nanoparticules comprennent chacune de manière indépendante :
une âme qui comprend un produit de réaction d'un composé à émission de lumière organique fonctionnalisé et d'un premier précurseur, dans lequel le composé à émission de lumière organique fonctionnalisé présente la structure de D-L-SiX₃, dans laquelle D est un luminophore, L est une liaison directe ou un groupe organique et X est un substituant hydrolysable ; et le premier précurseur est sélectionné parmi un premier composé de silane organique qui présente la structure de SiX¹₄ ; dans laquelle chaque X¹ est de manière indépendante un substituant hydrolysable ; et
une enveloppe qui comprend un produit de réaction d'un second précurseur, dans lequel le second précurseur est sélectionné parmi (a) un second composé de silane organique ayant la structure de SiX²₄ ; dans laquelle chaque X² est de manière indépendante un substituant hydrolysable.

6. Appareil à émission de lumière selon la revendication 1, dans lequel les premières et secondes nanoparticules sont chacune de manière indépendante préparées au moyen d'un procédé qui comprend :
(i) la fourniture d'un composé à émission de lumière organique fonctionnalisé, dans lequel le composé à émission de lumière organique fonctionnalisé présente la structure de D-L-SiX₃, dans laquelle D est un luminophore, L est une liaison directe ou un groupe organique et X est un substituant hydrolysable ;
(ii) l'ajout d'un premier précurseur, dans lequel le premier précurseur est sélectionné parmi un premier composé de silane organique ayant la structure de SiX¹₄, un premier composé organométallique ayant la structure de MX¹₃ ou de MX¹₄, ou des mélanges de ceux-ci ; dans laquelle chaque X¹ est de manière indépendante un substituant hydrolysable, et M est sélectionné parmi Al, Zr, Ti ou des combinaisons de ceux-ci ; et
(iii) l'ajout d'un second précurseur, dans lequel le second précurseur comprend (a) un second composé de silane organique qui présente la structure de SiX²₄, (b) un second composé organométallique de la structure de MX²₃ ou de MX²₄, ou des mélanges de ceux-ci ; dans laquelle chaque X² est de manière indépendante un substituant hydrolysable, et M est sélectionné parmi Al, Zr, Ti ou des combinaisons de ceux-ci ; pour ainsi obtenir les nanoparticules.

7. Appareil à émission de lumière selon la revendication 6, dans lequel le procédé comprend en outre :
(iv) l'ajout d'un agent de modification de surface ayant la structure de R¹ₘSi(R²)₄₋ₘ, dans laquelle R¹ est sélectionné parmi un C₁-C₂₀ alkyle substitué ou non substitué, un C₂-C₂₀ alkényle substitué ou non substitué, ou un groupe C₆-C₂₄ aryle substitué ou non substitué ; R² est un groupe hydrolysable ; et m est un entier de 1 à 3.

8. Appareil à émission de lumière selon la revendication 1, dans lequel les composés à émission de lumière organiques pour préparer les premières nanoparticules présentent la structure de la formule (II) : 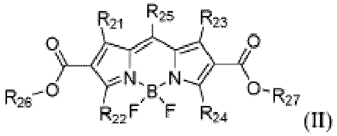 dans laquelle R₂₁ à R₂₅ sont, chacun de manière indépendante, sélectionnés parmi H, un halogène, -CN, -CF₃, -NO₂, un C₁-C₂₄ alkyle substitué ou non substitué, un C₂-C₂₄ alkényle substitué ou non substitué, un C₂-C₂₄ alkynyle substitué ou non substitué, un C₁-C₂₄ alcoxy substitué ou non substitué, un groupe C₃-C₂₀ cyclique ou hétérocyclique substitué ou non substitué, -SO₃H, sulfonate, -SO₂O-, un thioéther, un éther, une urée,-CO₂H, un ester, une amide, une amine, un groupe C₆-C₂₀ aromatique substitué ou non substitué ou un groupe C₅-C₂₀ hétéroaromatique substitué ou non substitué ; et R₂₆ et R₂₇ sont, chacun de manière indépendante, sélectionnés parmi un C₁-C₂₀ alkyle substitué ou non substitué, un C₂-C₂₀ alkényle substitué ou non substitué, un C₂-C₂₄ alkynyle substitué ou non substitué, un C₁-C₂ alcoxy substitué ou non substitué, un groupe C₆-C₂₄ aryle substitué ou non substitué _{;} un groupe C₃-C₂₀ cyclique ou hétérocyclique substitué ou non substitué, ou un groupe C₅-C₂₀ hétéroaromatique substitué ou non substitué.

9. Appareil à émission de lumière selon la revendication 1 ou 2, dans lequel les premières et secondes nanoparticules présentent chacune de manière indépendante une taille de particule dans la plage qui va de 10 à 2 000 nm.

10. Appareil à émission de lumière selon la revendication 1, dans lequel la longueur d'onde de la lumière en provenance de l'unité de rétroéclairage va de 430 à 500 nm.

11. Appareil à émission de lumière selon la revendication 1, dans lequel le réseau de conversion de couleur comprend en outre une ou plusieurs couches de blocage de la lumière bleue qui comprennent un ou plus d'un matériau d'absorption de la lumière bleue, qui sont placées sur le sommet de la couche de conversion de couleur rouge et/ou de la couche de conversion de couleur verte à distance de l'unité de rétroéclairage.

12. Appareil à émission de lumière selon la revendication 1, dans lequel la couche de conversion de couleur rouge comprend en outre des composés à émission de lumière rouge organiques, des phosphores inorganiques, des points quantiques ou des mélanges de ceux-ci.

13. Appareil à émission de lumière selon la revendication 1, dans lequel la couche de conversion de couleur verte comprend en outre des composés à émission de lumière verte organiques, des phosphores inorganiques, des points quantiques ou des mélanges de ceux-ci.

14. Dispositif électronique comprenant un appareil à émission de lumière selon l'une quelconque des revendications 1 à 13.

15. Dispositif électronique selon la revendication 14, dans lequel le dispositif électronique est sélectionné parmi les affichages LCD, les affichages LED ou les affichages OLED.
